(19) Europäisches Patentamt
European Patent Office
Office européen des brevets

(11) EP 3 567 088 A1

(12) EUROPEAN PATENT APPLICATION

(43) Date of publication:
**13.11.2019 Bulletin 2019/46**

(21) Application number: **18171912.1**

(22) Date of filing: **11.05.2018**

(51) Int Cl.:
***C09K 11/06*** *(2006.01)* ***G07D 7/00*** *(2016.01)*
***B42D 25/00*** *(2014.01)* ***H01L 51/00*** *(2006.01)*

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **Université de Genève**
**1211 Genève 4 (CH)**

(72) Inventors:
- **LACOUR, Jérôme**
**1211 Genève 4 (CH)**
- **BRUN, Elodie**
**1211 Genève 4 (CH)**
- **HOMBERG, Alexandre**
**1211 Genève 4 (CH)**
- **POGGIALI, Daniele**
**6900 Lugano (CH)**
- **ZINNA, Francesco**
**1211 Genève 4 (CH)**

(74) Representative: **KATZAROV S.A.**
**European Patent Attorneys**
**12, Avenue des Morgines**
**1213 Petit-Lancy (CH)**

# (54) FUNCTIONALIZED POLYETHER MACROCYCLIC COMPOUNDS AND USE THEREOF AS LUMINESCENT MARKERS

(57) The invention relates to chiral enantioenriched functionalized polyether macrocyclic compounds displaying bright circularly polarized light emission and use thereof as luminescent markers.

EP 3 567 088 A1

## Description

### Field of the Invention

The invention relates to chiral enantioenriched (enantiomerically enriched) functionalized polyether macrocyclic compounds displaying bright circularly polarized light emission and use thereof as luminescent markers.

### Background of the Invention

The protection of value documents and value commercial products by security means against counterfeiting, falsifying and illegal reproduction has retained a lot of attention these last years. Typical examples of security means currently used include security threads, windows, fibers, planchettes, foils, decals, holograms, watermarks, security inks comprising optically variable pigments, magnetic or magnetizable pigments, interference-coated particles, thermochromic pigments, photochromic pigments, luminescent compounds, infrared-absorbing compounds, ultraviolet-absorbing compounds. In particular, luminescent compounds are widely used as security means in security applications as marking materials. For example, luminescent compounds are suitable for the realization of machine-readable security elements.
There is still a need to improve the security of value documents, products and packaging by providing better security means, such as luminescent compounds having improved physicochemical properties, such as solubility, matrix compatibility, structure flexibility, etc.

### Summary of the Invention

An aspect of the present invention provides a dextrorotatory and levorotatory enantioenriched functionalized polyether macrocyclic compound of formula (I)

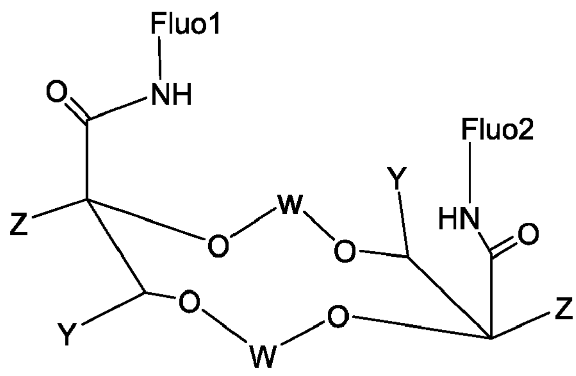

(I)

wherein

Fluol and Fluo2 are the same or different suitable fluorophores,
Y is selected from the group comprising $=CH_2$, $-CH_3$, $-CH_2$-A wherein A is selected from the group comprising -SH, -SR, heteroatoms selected from the group comprising S, N, O,
R is a functional group,
Z is H or halogen,
W is substituted or unsubstituted $C_4$-$C_6$-alkyl, wherein optionally at least one C atom is substituted by heteroatoms selected from the group comprising N, S and O, and wherein substituents are selected from the group comprising substituted or unsubstituted alkyl, substituted or unsubstituted heteroalkyl, substituted or unsubstituted aryl, substituted or unsubstituted heteroaryl, substituted or unsubstituted cycloalkyl, or substituted or unsubstituted heterocycloalkyl.

Another aspect of the present invention provides a security element for the protection of value documents and/or value commercial products comprising the polyether macrocyclic compound of the invention.
A further aspect of the present invention provides a use of the polyether macrocyclic compound of the invention against counterfeiting, falsifying and illegal reproduction of value documents and/or value commercial products.
A further aspect of the present invention provides a method for authenticating a value document and/or a value

commercial product, said method comprising the steps of

a) providing a value document and/or a value commercial product carrying at least one polyether macrocyclic compound of the invention or the security element of the invention;
b) illuminating the compound or the security element on said value document and/or value commercial product with at least one quality of light from at least one light source;
c) detecting the determined optical characteristics of the polyether macrocyclic compound of the invention through the sensing of light emitted by said compounds;
d) determining the value document's and/or the value commercial product's authenticity from the detected optical characteristics of the polyether macrocyclic compound of the invention.

Another aspect of the present invention provides a use of the polyether macrocyclic compound of the invention in organic light emitting diodes (OLED).

**Brief description of figures**

**Figure 1** shows the synthetic scheme for the making of functionalized polyether macrocycles.

**Figure 2** shows the synthetic scheme for possible functionalizations of the unsaturated polyether macrocycles.

**Figure 3** shows absorbance/photoluminescence and circularly polarized luminescence spectra of pyrene-18C6 in $CH_3CN$.

**Figure 4** shows absorbance/photoluminescence and circularly polarized luminescence spectra of pyrene-16C4 in $CH_2Cl_2$.

**Figure 5** shows absorbance/photoluminescence and circularly polarized luminescence spectra of NMI-18C6 in $CH_3CN$.

**Figure 6** shows absorbance/photoluminescence and circularly polarized luminescence spectra of perylene-18C6 in $CH_3CN$.

**Figure 7** shows a model for reversible switching, illustrated in the case of pyrene-18C4.

**Figure 8** shows normalized circularly polarized luminescence of (+)-pyrene-18C4 in $CH_2Cl_2$ in presence of an excess of $Na^+$ (grey lines) and in absence thereof (black lines) and the value at $\lambda$ = 480 nm of normalized circularly polarized luminescence of (+)-pyrene-18C4 in $CH_2Cl_2$, upon several cycles of $Na^+$ complexation (squares) / decomplexation (dots).

**Detailed description of the Invention**

All publications, patent applications, patents, and other references mentioned herein are incorporated by reference in their entirety. The publications and applications discussed herein are provided solely for their disclosure prior to the filing date of the present application. Nothing herein is to be construed as an admission that the present invention is not entitled to antedate such publication by virtue of prior invention. In addition, the materials, methods, and examples are illustrative only and are not intended to be limiting.
In the case of conflict, the present specification, including definitions, will control.
Unless defined otherwise, all technical and scientific terms used herein have the same meaning as is commonly understood by one of skill in art to which the subject matter herein belongs. As used herein, the following definitions are supplied in order to facilitate the understanding of the present invention.
The term "comprise" is generally used in the sense of include, that is to say permitting the presence of one or more features or components. In addition, as used in the specification and claims, the language "comprising" can include analogous embodiments described in terms of "consisting of" and/or "consisting essentially of'.
As used in the specification and claims, the term "and/or" used in a phrase such as "A and/or B" herein is intended to include "A and B", "A or B", "A", and "B".
As used in the specification and claims, the singular forms "a", "an" and "the" include plural references unless

the context clearly dictates otherwise.

As used in the specification and claims, the term "at least one" used in a phrase such as "at least one C atom" can mean "one C atom" or "two C atoms" or more C atoms.

The term "substituted" means that the referenced group is substituted with one or more additional group(s). In certain embodiments, the one or more additional group(s) are individually and independently selected from amide, alkyl, cycloalkyl, heteroalkyl, aryl, heteroaryl, heteroalicyclic, hydroxy, alkoxy, aryloxy, alkylthio, arylthio, alkylsulfoxide, arylsulfoxide, ester, alkylsulfone, arylsulfone, cyano, halo, alkoyl, alkoyloxo, carboxyl, isocyanato, thiocyanato, isothiocyanato, nitro, haloalkyl, haloalkoxy, haloaryl, amino, alkylamino, dialkyl-amino, amido, azido, alkylphosphate, arylphosphate, arylalkylphosphate, alkylphosphine, arylphosphine, phosphoalkyl, phosphonate, phosphate, phosphine, phosphine oxide, phosphoryl, phosphoaryl.

An "alkyl" group refers to an aliphatic hydrocarbon group. Reference to an alkyl group includes "saturated alkyl" and/or "unsaturated alkyl". The alkyl group, whether saturated or unsaturated, includes branched, straight chain, or cyclic groups. By way of example only, alkyl includes methyl, ethyl, propyl, iso-propyl, n-butyl, iso-butyl, sec-butyl, tert-butyl, pentyl, iso-pentyl, neo-pentyl, and hexyl. In some embodiments, alkyl groups include, but are in no way limited to, methyl, ethyl, propyl, isopropyl, butyl, iso-butyl, tertiary butyl, pentyl, hexyl, ethenyl, propenyl, butenyl, cyclopropyl, cyclobutyl, cyclopentyl, cyclohexyl, and the like. A "heteroalkyl" group substitutes any one of the carbons of the alkyl group with a heteroatom having the appropriate number of hydrogen atoms attached (e.g., a $CH_2$ group to an NH group or an O group).

An "alkoxy" group refers to a (alkyl)O- group, where alkyl is as defined herein.

The term "alkylamine" refers to the $-N(alkyl)_xH_y$ group, wherein alkyl is as defined herein and x and y are selected from the group x=1, y=1 and x=2, y=0. When x=2, the alkyl groups, taken together with the nitrogen to which they are attached, optionally form a cyclic ring system.

An "amide" is a chemical moiety with formula -C(=O)NHR or -NHC(=O)R, where R is selected from alkyl, cycloalkyl, aryl, heteroaryl (bonded through a ring carbon) and heteroalicyclic (bonded through a ring carbon).

The term "ester" refers to a chemical moiety with formula -C(=O)OR or -OC(=O)R, where R is selected from the group consisting of alkyl, cycloalkyl, aryl, heteroaryl and heteroalicyclic.

As used herein, the term "aryl" refers to an aromatic ring wherein each of the atoms forming the ring is a carbon atom. Aryl rings disclosed herein include rings having three, four, five, six, seven, eight, nine, or more than nine carbon atoms. Aryl groups are optionally substituted. Examples of aryl groups include, but are not limited to phenyl and naphthalenyl.

The term "cycloalkyl" refers to a monocyclic or polycyclic non-aromatic radical, wherein each of the atoms forming the ring (i.e. skeletal atoms) is a carbon atom. In various embodiments, cycloalkyls are saturated, or partially unsaturated. In some embodiments, cycloalkyls are fused with an aromatic ring. Cycloalkyl groups include groups having from 3 to 20 ring atoms. Monocyclic cycloalkyls include, but are not limited to, cyclopropyl, cyclobutyl, cyclopentyl, cyclohexyl, cycloheptyl, and cyclooctyl.

The term "heterocyclo" refers to hetero aromatic and heteroalicyclic groups, which have one or more skeletal ring atoms selected from an atom other than carbon, e.g. , boron, oxygen, nitrogen, sulfur, phosphorus, silicon, or combinations thereof; preferably selected from nitrogen, oxygen and sulfur. In certain instances, each heterocyclic group has from 4 to 20 atoms in its ring system. Non-aromatic heterocyclic groups include groups having 3 atoms in their ring system, but aromatic heterocyclic groups must have at least 5 atoms in their ring system. The heterocyclic groups include benzo-fused ring systems. An example of a 3-membered heterocyclic group is aziridinyl (derived from aziridine). An example of a 4-membered heterocyclic group is azetidinyl (derived from azetidine). An example of a 5-membered heterocyclic group is thiazolyl. An example of a 6-membered heterocyclic group is pyridyl, and an example of a 10-membered heterocyclic group is quinolinyl. Examples of non-aromatic heterocyclic groups are pyrrolidinyl, tetrahydrofuranyl, dihydrofuranyl, tetrahydrothienyl, tetrahydropyranyl, dihydropyranyl, tetrahydrothiopyranyl, piperidino, morpholino, thiomorpholino, thioxanyl, piperazinyl, aziridinyl, azetidinyl, oxetanyl, thietanyl, homopiperidinyl, oxepanyl, thiepanyl, oxazepinyl, diazepinyl, thiazepinyl, 1,2,3,6-tetrahydropyridinyl, 2-pyrrolinyl, 3-pyrrolinyl, indolinyl, 2H- pyranyl, 4H-pyranyl, dioxanyl, 1,3-dioxolanyl, pyrazolinyl, dithianyl, dithiolanyl, dihydropyranyl, dihydrothienyl, dihydrofuranyl, pyrazolidinyl, imidazolinyl, imidazolidinyl, 3-azabicyclo[3.1.0]hexanyl, 3-azabicyclo[4.1.0]heptanyl, 3H-indolyl and quinolizinyl. Examples of aromatic heterocyclic groups are pyridinyl, imidazolyl, pyrimidinyl, pyrazolyl, triazolyl, pyrazinyl, tetrazolyl, furyl, thienyl, isoxazolyl, thiazolyl, oxazolyl, isothiazolyl, pyrrolyl, quinolinyl, isoquinolinyl, indolyl, benzimidazolyl, benzofuranyl, cinnolinyl, indazolyl, indolizinyl, phthalazinyl, pyridazinyl, triazinyl, isoindolyl, pteridinyl, purinyl, oxadiazolyl, thiadiazolyl, furazanyl, benzofurazanyl, benzothiophenyl, benzothiazolyl, benzoxazolyl, quinazolinyl, quinoxalinyl, naphthyridinyl, and furopyridinyl.

The term "heteroaryl" refers to an aryl group, which has one or more skeletal ring atoms selected from an atom other than carbon, e.g. , boron, oxygen, nitrogen, sulfur, phosphorus, silicon, or combinations thereof; preferably selected from nitrogen, oxygen and sulfur. In certain embodiments, heteroaryl groups are monocyclic or polycyclic.

A "heteroalicyclic" group or "heterocyclo" group refers to a cycloalkyl group, which has one or more skeletal ring atoms selected from an atom other than carbon, e.g. , boron, oxygen, nitrogen, sulfur, phosphorus, silicon, or

combinations thereof; preferably selected from nitrogen, oxygen and sulfur. In various embodiments, the radicals are with an aryl or heteroaryl.

The term "halo" or, alternatively, "halogen" means fluoro, chloro, bromo and iodo.

The terms "haloalkyl," and "haloalkoxy" include alkyl and alkoxy structures that are substituted with one or more halogens. In embodiments, where more than one halogen is included in the group, the halogens are the same or they are different. The terms "fluoroalkyl" and "fluoroalkoxy" include haloalkyl and haloalkoxy groups, respectively, in which the halo is fluorine.

The term "heteroalkyl" include optionally substituted alkyl, alkenyl and alkynyl radicals which have one or more skeletal chain atoms selected from an atom other than carbon, e.g. boron, oxygen, nitrogen, sulfur, phosphorus, silicon, or combinations thereof.

The term "phosphonate" refers to the group $-P(O)(OR^1)_2$, wherein each $R^1$ is independently selected from the group comprising, but not limited to, hydrogen, $C_1$-$C_6$-alkyl, phenyl, $C_1$-$C_6$-alkyl-$C_6H_5$, Li, Na, K, Cs, Mg, and Ca.

The term "phosphate" refers to the group $-OP(O)(OR^1)_2$, wherein each $R^1$ is independently selected from the group comprising, but not limited to, hydrogen, $C_1$-$C_6$-alkyl, phenyl, $C_1$-$C_6$-alkyl-$C_6H_5$, Li, Na, K, Cs, Mg, and Ca.

The term "phosphine" refers to the group $-P(R^2)_2$, wherein each R2 is independently selected from the group comprising, but not limited to, hydrogen, $C_1$-$C_6$-alkyl, phenyl and $C_1$-$C_6$-alkyl-$C_6H_5$.

The term "phosphine oxide" refers to the group $-P(O)R^3{}_2$, wherein $R^3$ is independently selected from the group comprising, but not limited to, hydrogen, $C_1$-$C_6$-alkyl, phenyl, and $C_1$-$C_6$-alkyl-$C_6H_5$, and amine (to give phosphonamidate) selected from the group comprising $-NR'_2$, wherein each R' is independently selected from the group comprising, but not limited to hydrogen, $C_1$-$C_6$-alkyl, $C_1$-$C_6$-alkyl-$C_6H_5$, and phenyl, wherein when both R' are $C_1$-$C_6$-alkyl both R' together may form an $-NC_3$ to an $-NC_5$ heterocyclic ring with any remaining alkyl chain forming an alkyl substituent to the heterocyclic ring.

Luminescence is understood to mean emitting electromagnetic radiation and/or light after excitation. This expression comprises both fluorescence and phosphorescence.

Circularly polarized luminescence (CPL) is the property displayed by some luminescent chiral enantioenriched compounds to emit left and right circularly polarized light with different intensities.

An aspect of the present invention provides a dextrorotatory and levorotatory enantioenriched functionalized polyether macrocyclic compound of formula (I)

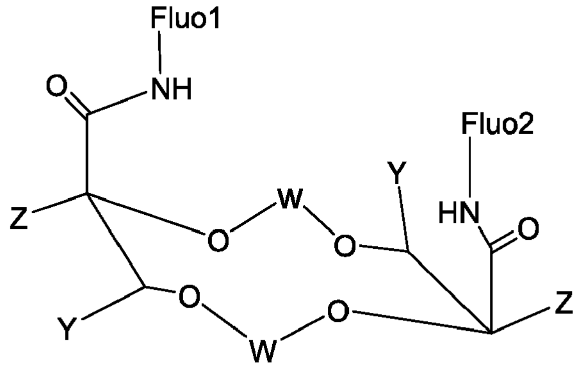

(I)

wherein

Fluol and Fluo2 are the same or different suitable fluorophores,

Y is selected from the group comprising $=CH_2$, $-CH_3$, $-CH_2$-A wherein A is selected from the group comprising -SH, -SR, heteroatoms selected from the group comprising S, N, O; in some preferred embodiments, Y is selected from the group comprising $=CH_2$, $-CH_3$, $-CH_2$-S-$(CH_2)_2$-SH; in othe preferred embodiment, Y is $=CH_2$ or $-CH_3$,

R is a functional group, preferably the functional group is selected from the group comprising alkyl group, aryl group, hydroxyl group, amino group, carbonyl group, carboxy group, thiol group, alkylthio group, amide group, and modified forms thereof,

Z is H or halogen, preferably selected from the group comprising H, F, Cl, Br, I, most preferably selected from H or F; in some embodiments, Z is H,

W is substituted or unsubstituted $C_4$-$C_6$-alkyl, wherein optionally at least one C atom is substituted by heteroatoms selected from the group comprising N, S and O, and wherein substituents are selected from the group comprising substituted or unsubstituted alkyl, substituted or unsubstituted heteroalkyl, substituted or unsubstituted aryl, substituted or unsubstituted heteroaryl, substituted or unsubstituted cycloalkyl, or substituted or unsubstituted heterocycloalkyl; in some embodiments, W is selected from the group comprising $C_4$-alkyl, $C_5$-alkyl, $-(CH_2)_2-O-(CH_2)_2-$, $-(CH_2)_2-N-(CH_2)_2-$; in another embodiments, W is $C_4$-$C_6$-alkyl and wherein at least one C atom is substituted by heteroatoms selected from the group comprising N and O. In a preferred embodiment, one C atom is substituted by O.

The functionalized polyether macrocyclic compounds of formula (I) of the present invention exist as dextrorotatory and levorotatory enantiomers.

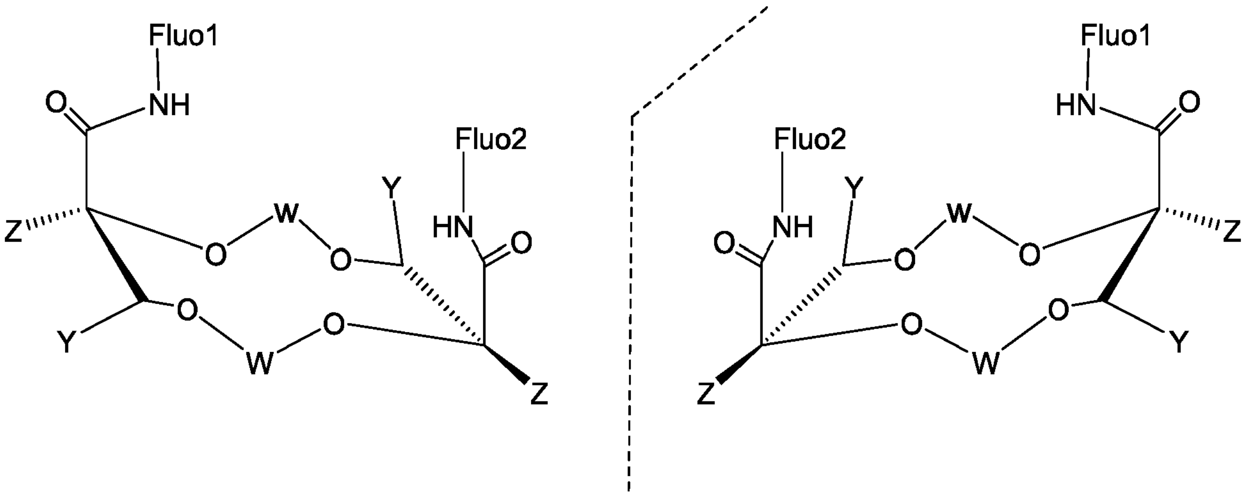

Thus a functionalized polyether macrocyclic compounds of formula (I) of the invention enantiomerically enriched in either dextrorotatory or levorotatory enantiomer are either a mixture of dextrorotatory and levorotatory enantiomers enriched in the dextrorotatory enantiomer or a mixture of dextrorotatory and levorotatory enantiomers enriched in the levorotatory enantiomer.

The terms "enantioenriched" or "enantiomerically enriched" denotes the fact that one enantiomer is present as a mixture with the other enantiomer in a proportion amounting to >50%, preferably >65%, most preferably >90% or >99%.

The structures of the polyether macrocyclic compounds of the invention relate to all possible chiral stereoisomers.

The terms "functionalized" and "functionalization" as used herein, indicate the appropriate chemical modifications of a molecular structure of the polyether macrocyclic compound of the invention resulting in attachment of a functional group to the molecular structure. The term "functional group" as used herein indicates specific groups of atoms within a molecular structure that are responsible for the characteristic chemical reactions of that structure. Exemplary functional groups include hydrocarbons, groups containing boron, groups containing halogen, groups containing oxygen, groups containing nitrogen and groups containing phosphorus, sulfur and silicon all identifiable by a skilled person. In some embodiments of the present invention, "functional group" refers to a functional group providing a particular reactive moiety that is capable of reacting to permit attachment (for example via the formation of covalent and non-covalent bonds) of the compound of the present invention to another substance, compound, protein, nucleotide, surface, nanocluster, nanoassembly, gel, polymer, etc.... Examples of functional groups include reactive alkenes, alkynes, amines, amides, alcohols, esters, ketones, halogens, acyl halides, aldehydes, thiols, phosphate groups, silyl and silyloxy groups or carboxylic acid moieties.

Fluol and Fluo2 are any suitable fluorophores, such as substituted and unsubstituted aryl amine, heteroaryl amine, and complex/assembly thereof that exhibit CPL associated with excimer or monomer emission. In a preferred embodiment, Fluol and Fluo2 are independently selected from the group comprising

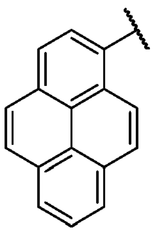
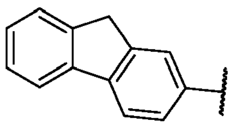
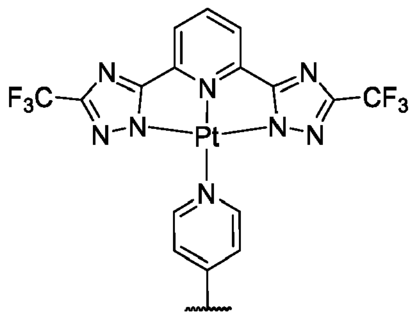
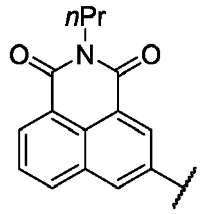

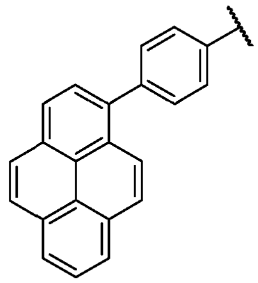
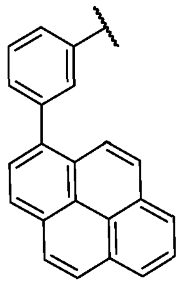
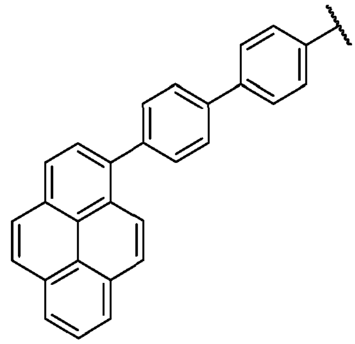
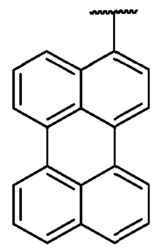

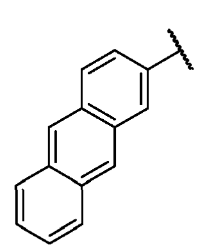
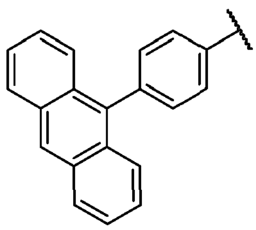
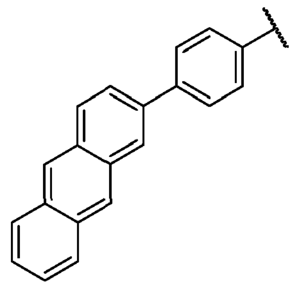

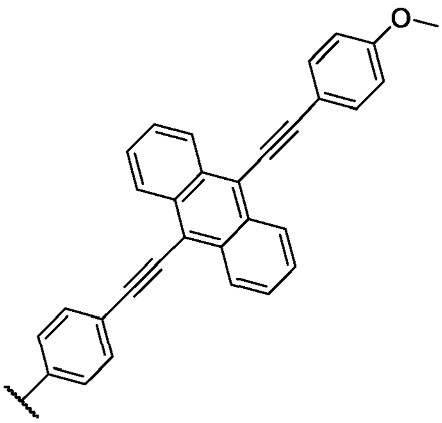
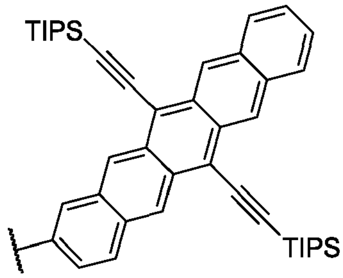

In some embodiments,

Y is selected from the group comprising $=CH_2$, $-CH_3$, $-CH_2-S-(CH_2)_2-SH$,
Z is H or F,
W is is selected from the group comprising $C_4$-alkyl, $C_5$-alkyl, $-(CH_2)_2-O-(CH_2)_2-$,$-(CH_2)_2-N-(CH_2)_2-$.

In further embodiments, the polyether macrocyclic compound of the invention is selected from the group com-

prising

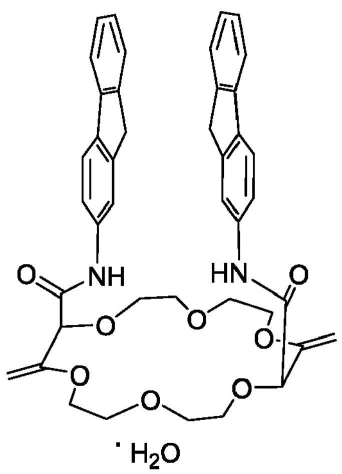

· $H_2O$

Fluorene-18C6

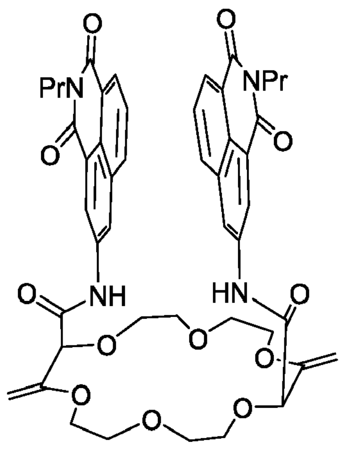

· $H_2O$

NMI-18C6

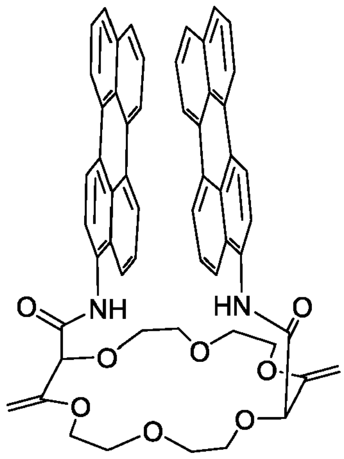

· $H_2O$

Perylene-18C6

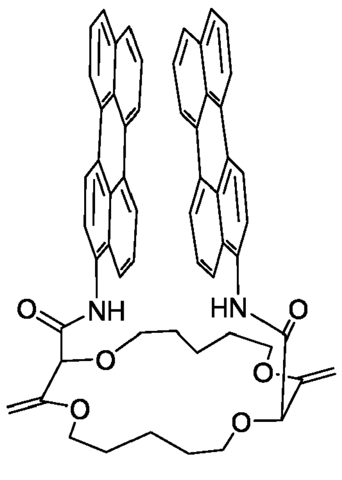

Perylene-18C4

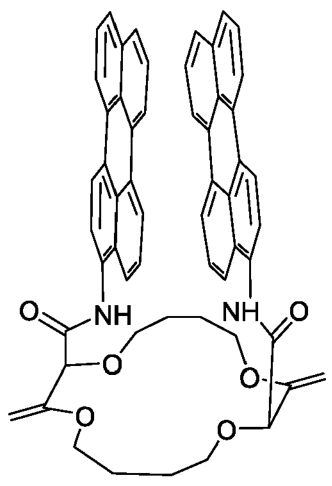

· $CH_2Cl_2$

Perylene-16C4

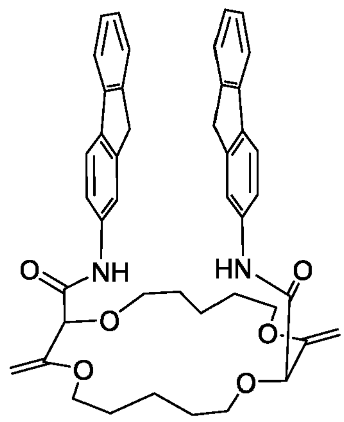

Fluorene-18C4

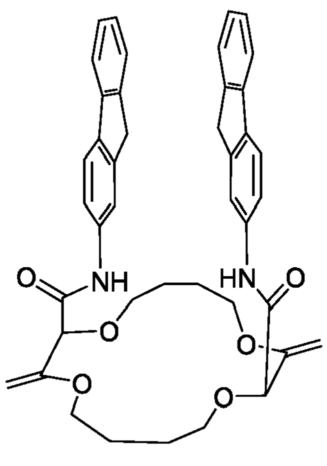

Fluorene-16C4

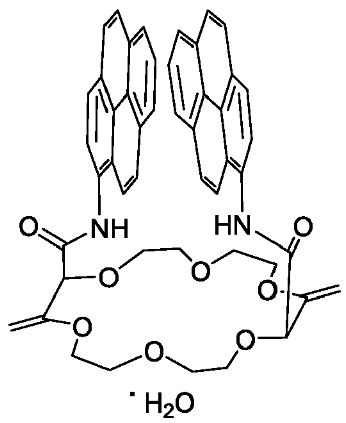

· $H_2O$

Pyrene-18C6

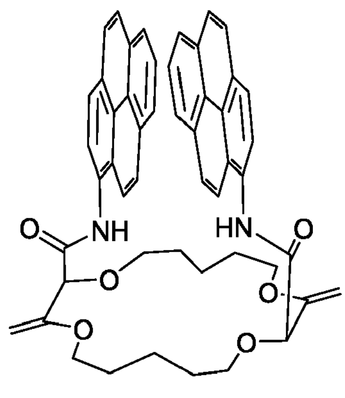

Pyrene-18C4

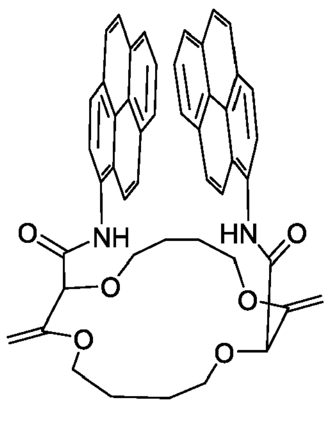

Pyrene-16C4

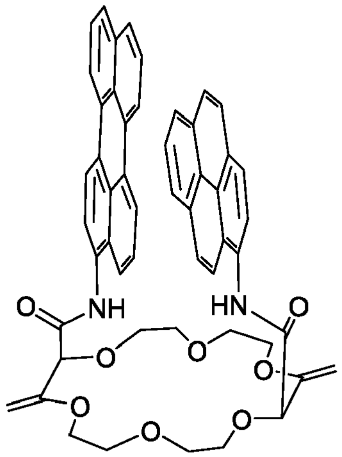

Perylene-pyrene-18C6

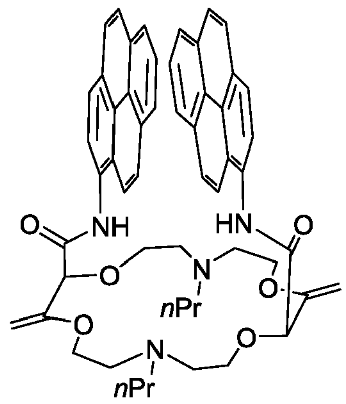

Pyrene-aza-18C6

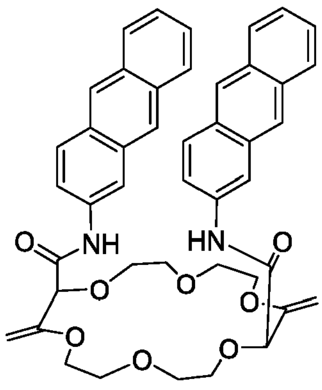

· $H_2O$

2-Anthracene-18C6

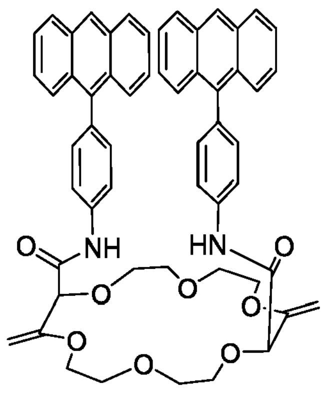

· $H_2O$

*p*-9-Anthracene-anilide-18C6

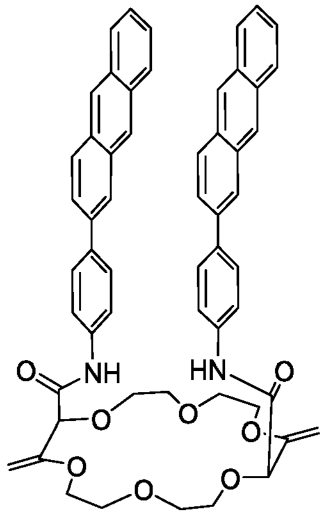

· $H_2O$

*p*-2-Anthracene-anilide-18C6

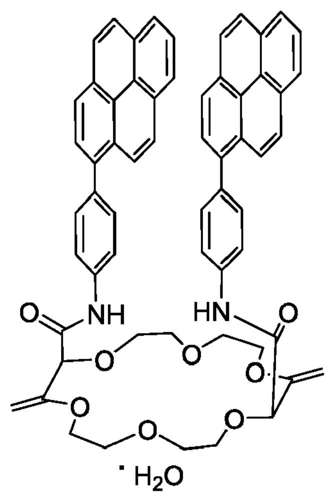

*p*-Pyrene-anilide-18C6

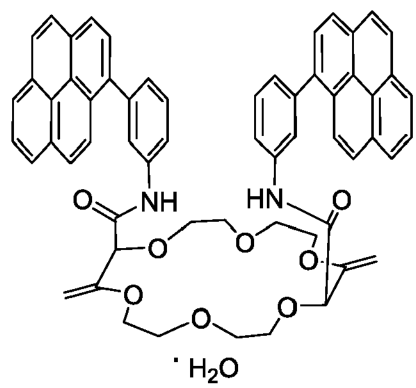

*m*-Pyrene-anilide-18C6

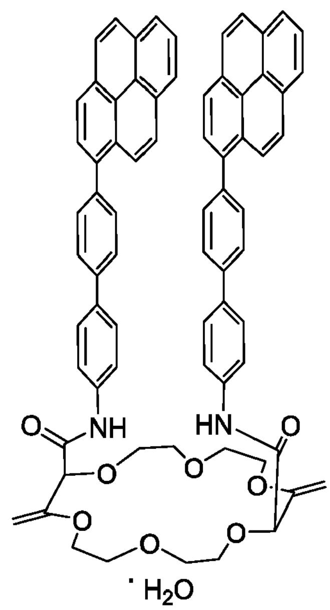

*p*-Pyrene-*p*-Ph-anilide-18C6

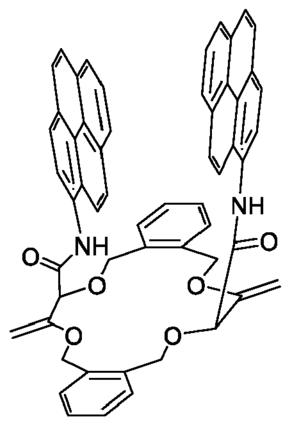

Pyrene-benzo-16C4

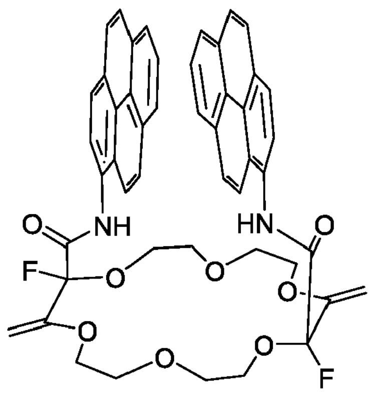

Pyrene-F-18C6

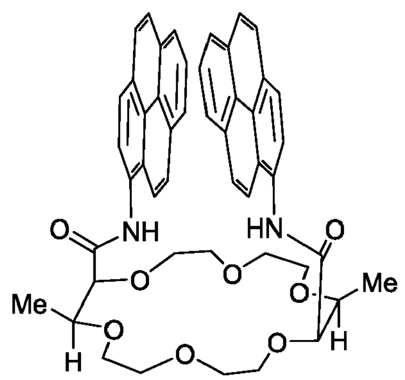

Pyrene-18C6-$H_2$

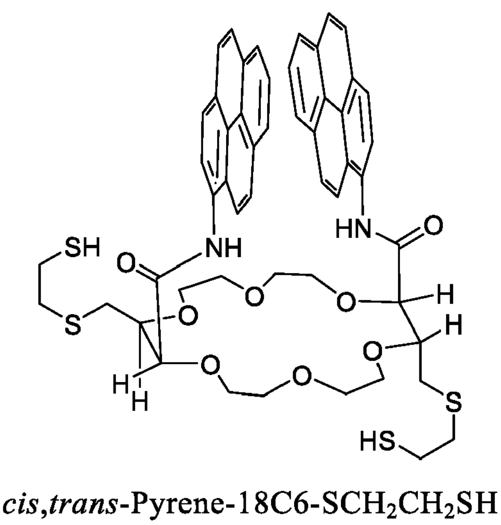

*cis,trans*-Pyrene-18C6-$SCH_2CH_2SH$

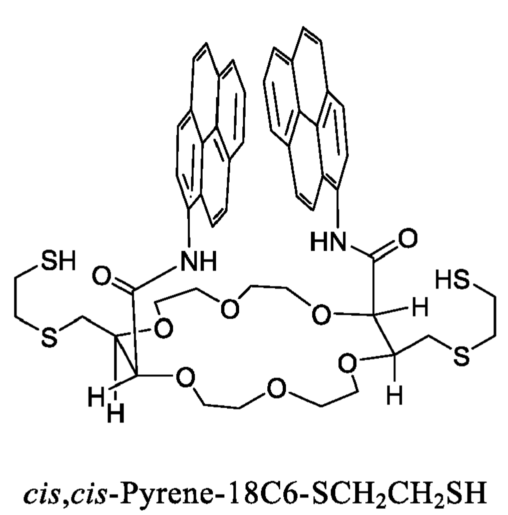

*cis,cis*-Pyrene-18C6-$SCH_2CH_2SH$

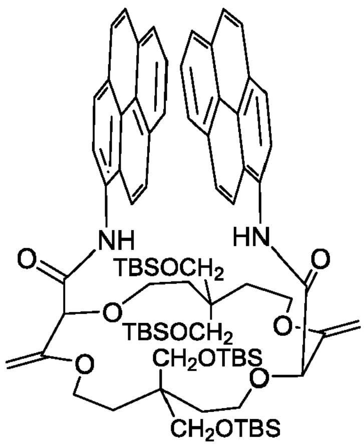

Pyrene-18C4-*gem*di$CH_2OTBS$

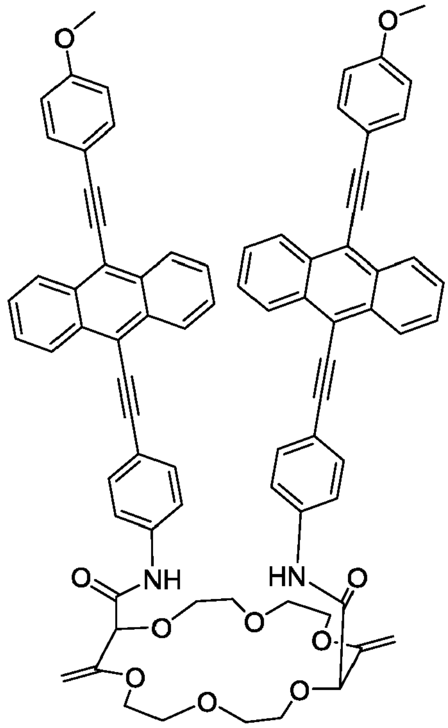

DiPhEthynylAnthracene-18C6

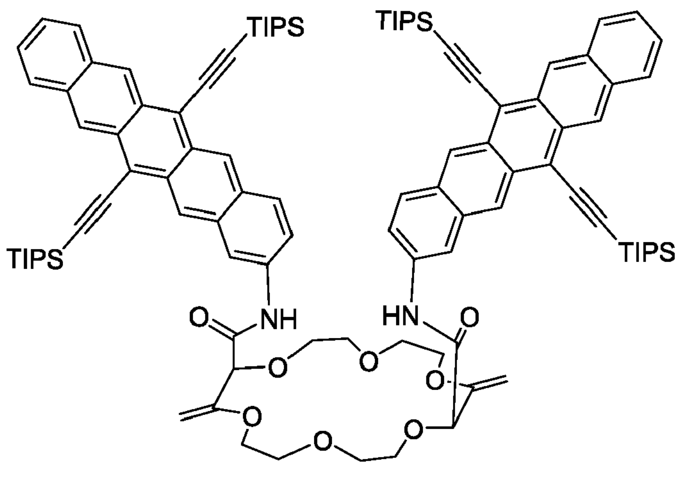

TIPS-Pentacene-18C6

The polyether macrocyclic compounds of the present invention able to emit light with high degree of circular polarization can have several technological applications, such as CPL-based interactions reporters and circularly polarized OLEDs, including luminescent security inks where CPL can be introduced as an additional safety feature, robust to counterfeiting.

According to an aspect, the present invention provides use of the polyether macrocyclic compounds of the invention in organic light emitting diodes (OLED).

According to a further aspect, the present invention provides organic light emitting diodes (OLED) containing the polyether macrocyclic compounds of the invention.

The polyether macrocyclic compounds of the invention, that are able to emit circularly polarized electroluminescence, can be used to manufacture organic light emitting diodes (OLED) able to emit circularly polarized electroluminescence without using passive optical elements, such as polarizing filters. Typically, the polyether macrocyclic compounds of the invention are contained in the active layer of the OLED.

The degree of circularization is quantified by the dissymmetry factor *g*, defined as:

$$g = \frac{2\,(I_L - I_R)}{(I_L + I_R)}$$

wherein $I_L$ and $I_R$ are the left and right circularly polarized components of the emission respectively.

The synthetic scheme of the polyether macrocyclic compounds of the invention is shown on Figure 1. Synthetic building blocks are prepared by Rh(II)-catalyzed decomposition of α-diazo-β-keto ester in presence of cyclic ethers or morpholines used as reagent or solvent. These platforms are then transformed into the corresponding functionalized polyether macrocycles in a single step through a tandem amidation/olefin transposition process. For instance, 1-amino-fluorene, 3-amino-NMI (*N*-propyl-1,8-naphthalene monoimide), 1-amino-pyrene and 1-amino-perylene can be used as valuable fluorophores, allowing to efficiently tune the emission region. The corresponding polyether macrocycles are obtained as single diastereomers (NMR monitoring, diastereomeric ratio d.r. > 49:1). Functionalization can be further achieved on these scaffolds, such as hydrogenation, thiol-ene, cross-coupling reactions. CSP-HPLC resolution was performed for each compound. Typical but not restricted conditions are using a CHIRALPAK® IG column and a mixture of $CH_2Cl_2$ (+ 0.1% $Et_2NH$) and $CH_3CN$ (+ 0.1% $Et_2NH$) as mobile phase. In all cases, an efficient separation could be attained, with good selectively factors, which allowed to obtain enantioenriched samples on a semi-preparative scale.

Enantioenriched functionalized polyether macrocyclic compounds of the invention enantiomerically enriched in either dextrorotatory or levorotatory enantiomer have advantage over the racemic mixture in that the racemic mixture does not possess any chiroptical properties, including circularly polarized luminescence. In addition, the enantioenriched polyether macrocyclic compounds of the present invention provide new modular system that can display bright fluorescence, including excimer emission (from blue to yellow) and associated circularly polarized luminescence with g factors up to $10^{-2}$ and higher. The main advantages of the polyether macrocyclic compounds of the invention are (i) modularity of the macrocycle ring size and nature, (ii) modularity of the fluorophores inserted onto the macrocycles, (iii) tunability of the emission wavelength (due to fluorophore modularity), (iv) modularity of the terminal olefins that can be considered as molecular handles, (v) modularity by insertion of heteroatoms, such as N, O and S, in the macrocycle or substituents on the chain elements such as C, N and S, (vi) straightforward enantiomeric separation of the functionalized macrocycles through chiral stationary phase chromatography.

Using enantioenriched polyether macrocyclic compounds of the invention, obtained through CSP-HPLC resolution, the circularly polarized luminescence associated with the excimer fluorescence can be completely or partially quenched upon addition of cations, such as $Na^+$ or $Ba^{2+}$. Indeed, upon binding of external compounds, such as water, solvents (such as halogenated solvents, alcohols), monovalent or divalent cations (such as metal ions, ammonium salts, pyridinium salts, alkali or alkaline earth salts), major conformational changes may occur. As a consequence, the fluorophores may part from each other elongating the distance between the chromophores. The excimer fluorescence and allied CPL are at least partially quenched and the characteristic emission of (monomeric) fluorophores is observed. For several systems, a complete recovery of CPL signals over several cycles is observed after reversible complexation of the cation.

In the present invention, the inventors took advantage of this unique ability to induce and cancel excimer fluorescence to develop a family of enantiomerically enriched chiroptical switches with a large and tunable wavelength emission range. Upon complexation/decomplexation of guests like metal ions, the CPL signal is reversibly quenched establishing a rare on/off CPL switching behavior for the functionalized polyether macrocyclic compounds of the invention.

Thus an aspect of the present invention provides a method for reversibly cancelling or partially cancelling the excimer fluorescence of the polyether macrocyclic compounds of the invention, the method comprising the steps of:

- contacting the polyether macrocyclic compound of the invention with an external compound, preferably selected from the group comprising water, solvents (such as halogenated solvents, alcohols), monovalent or divalent cations (such as metal ions, ammonium salts, and pyridinium salts) and alkali or alkaline earth salts, thereby providing a system which results in cancellation or partial cancellation of the excimer fluorescence and the circularly polarized luminescence signal associated with it.
- recovering the excimer fluorescence and the circularly polarized luminescence signal associated with it by contacting the system resulting from the previous step with a scavenger capable of removing the external compound.

In a preferred embodiment, the metal ion is removed by using a suitable crown ether (preferentially 18-Crown-6) as a scavenger.

Another aspect of the present invention provides a composition comprising the polyether macrocyclic compounds of the invention. According to an embodiment, the composition is a security element for the protection of value documents and/or value commercial products comprising the polyether macrocycle compounds of the invention. In the context of the present invention, the term "protection" means protection against counterfeiting, falsifying and illegal

reproduction. According to another embodiment, the security element is selected from the group comprising luminescent security inks, luminescent security pigments or coating compositions. In another embodiment, the value documents and/or the value commercial products are selected from the group comprising banknotes, passports, identity documents, driving licenses, official permissions, official certificates, access documents, stamps, tax stamps, transportation tickets, event tickets, labels, foils, packages, pharmaceutical products, spare parts, consumer goods, security papers, vouchers.

The polyether macrocyclic compounds of the invention can be used in a security element for the protection against counterfeiting, falsifying and illegal reproduction of value documents and/or value commercial products. Advantageously, the functionalized polyether macrocyclic compounds of the invention can be used as a machine readable material. Typically, the polyether macrocyclic compounds of the invention can be incorporated into an ink or coating composition so as to be applied onto the value documents and/or value commercial products. The polyether macrocyclic compounds of the invention can be dissolved or dispersed within a polymer binder component of the ink or coating composition. Alternatively, the polyether macrocyclic compounds of the invention can be incorporated in the value documents and/or value commercial products; in particular the polyether macrocyclic compounds of the invention can be incorporated in the substrate of the value documents and/or value commercial products, the substrate including without limitation fibrous materials (for example celluloses and paper-containing materials), plastics, polymers, composite materials, metals or metalized materials and combinations thereof.

Another aspect of the present invention provides for a use of the polyether macrocyclic compounds of the invention against counterfeiting, falsifying and illegal reproduction of value documents and/or value commercial products.

Authentication aspects are of crucial importance for value documents, such as banknotes, and for value commercial products in retail applications, where there is a potential risk of counterfeiting, falsifying, illegal reproducing and/or substitution of the original documents and/or products by counterfeit or diverted ones. For this reason, authentication applications and track & trace applications in this field must be combined with at least one security element, able to certify the authenticity of the marked value document and/or value commercial product as an original one.

Thus another aspect of the present invention provides a method for authenticating a value document and/or a value commercial product, said method comprising the steps of

a) providing a value document and/or a value commercial product carrying at least one polyether macrocyclic compound of the invention or the composition of the invention;

b) illuminating the polyether macrocyclic compound or the composition on said value document and/or value commercial product with at least one quality of light from at least one light source;

c) detecting the determined optical characteristics of the compound of the invention through the sensing of light emitted by said polyether macrocyclic compounds;

d) determining the value document's and/or the value commercial product's authenticity from the detected optical characteristics of the polyether macrocyclic compound of the invention.

In an embodiment, said light source is a spectrally selective light source. In another embodiment, said light source is chosen from, but not limited to, the group comprising ambient light, incandescent light, laser diodes, light emitting diodes, and the light sources having color filters.

According to an embodiment of the method, the detecting step c) comprises using polarized luminescence spectroscopy to detect circularly polarized luminescence of the polyether macrocyclic compound of the invention.

Alternatively, the marking is authenticated under light source with the help of a passive detecting means such as an optical filter. A preferred such passive detecting means is a left-handed or a right-handed circular polarizing filter, or a juxtaposition of both. Optionally, the polarization filter can be combined with color filters, in order to reduce the spectral bandwidth to the spectral emission band of the polyether macrocyclic compound of the invention, and hence to reduce background contributions. More than one optical filter may be used in conjunction.

Also alternatively, the marking is authenticated with the help of an electro-optical authentication device. In a first embodiment, said device comprises at least one photocell, in combination with a circular polarization filter and a non-polarized or linearly polarized light source. In another embodiment said device comprises an electro-optic camera, such as a linear CCD sensor array, a 2-dimensional CCD image sensor array, a linear CMOS image sensor array, a 2-dimensional CMOS image sensor array, or a photomultiplier tube in combination with a circular polarization filter and a non-polarized or linearly polarized light source. Optionally, the circular polarization filter or the non-polarized or linearly polarized light source in the above embodiments can be combined with color filters, to select a particular spectral domain and to enhance the contrast ratio of the light emitted from the polyether macrocyclic compound of the invention to the light reflected and/or emitted from the background. The circular polarization filters can generally also be replaced by an electro-optic polarization switch or photoelastic modulator. Such device is known in the art, for example from DE 102 11 310 B4, and allows to select one or the other circular polarization state by an applied corresponding voltage.

In all cases of the polyether macrocyclic compounds of the invention, the marking of the present invention is authenticated by verifying one or more of its characteristic properties, namely the circular polarization state of the emitted

light from the marking. The light source or the polarized light detection equipment or both may be chosen to operate in the visible, the infrared, or the UV region of the electromagnetic spectrum, or in a combination of these, according to the optical characteristics of the marking.

Another aspect of the present invention provides the use of the compounds of the invention as fluorescent tags for marking substances, value documents, value commercial products, proteins, nucleotides, cells, tissues, etc...

Those skilled in the art will appreciate that the invention described herein is susceptible to variations and modifications other than those specifically described. It is to be understood that the invention includes all such variations and modifications without departing from the spirit or essential characteristics thereof. The invention also includes all of the steps, features, compositions and compounds referred to or indicated in this specification, individually or collectively, and any and all combinations or any two or more of said steps or features. The present disclosure is therefore to be considered as in all aspects illustrated and not restrictive, the scope of the invention being indicated by the appended Claims, and all changes which come within the meaning and range of equivalency are intended to be embraced therein.

The foregoing description will be more fully understood with reference to the following Examples. Such Examples, are, however, exemplary of methods of practising the present invention and are not intended to limit the scope of the invention.

**Examples**

**I) Synthesis of functionalized polyether macrocycles**

**Procedure for the synthesis of functionalized polyether macrocycles**

In a one neck flask under nitrogen atmosphere, dry tetrahydrofuran (c = 0.1 M) was added to 1 equivalent of an appropriate macrocyclic building block and 3 equivalents of the appropriate fluorophore amine (as one component or as a mixture of two). The mixture was cooled down to -100 °C. Then 4 equivalents of freshly sublimed ***t*-BuOK** were added in one portion. After stirring for 1-2 minutes at -100 °C, the cooling bath was removed and the reaction was allowed to reach 25 °C on its own and stirred for an additional 3 to 4 hours. Upon completion, the reaction was quenched by adding a few drops of methanol and directly purified by column chromatography ($SiO_2$) without further treatment. A second column chromatography ($Al_2O_3$, neutral) could be required. Finally, the resulting oil or solid was purified by selective precipitation (dissolution in a minimal amount of $CH_2Cl_2$ or ethyl acetate required for solubility, followed by addition of a large excess of pentane) affording the desired chiral polyether macrocycle. The enantioenriched compounds were obtained by CSP-HPLC resolution.

**Pyrene-18C6**

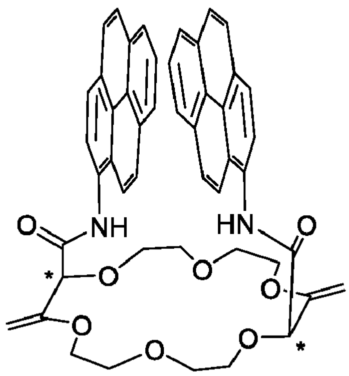

**Purification conditions:**

Column eluent ($SiO_2$): $CH_2Cl_2$/methanol gradient (100:0, 95:5, 90:10).
Precipitation: $CH_2Cl_2$ then pentane
**Yield:** 60%, off white solid
**CSP-HPLC:** semi-preparative IG, $CH_2Cl_2$ (+0.1% $Et_2NH$)/$CH_3CN$ (+0.1% $Et_2NH$) = 7:3, 2 mL/min, 20 °C
**$^1$H-NMR** (500 MHz, $CDCl_3$, 298 K): δ/ppm = 3.74 - 3.81 (m, 4H), 3.95 - 4.03 (m, 8H), 4.08 - 4.13 (m, 4H), 3.98 - 4.01 (m, 2H), 4.39 (d, *J* = 2.7 Hz, 2H), 4.52 (d, *J* = 2.7 Hz, 2H), 4.55 (s, 2H), 7.34 (d, *J* = 8.1 Hz, 2H), 7.40 (d, *J* =

8.8 Hz, 2H), 7.48 (d, *J* = 9.1 Hz, 2H), 7.57 (d, *J* = 8.8 Hz, 2H), 7.64 - 7.66 (m, 2H), 7.70 (t, *J* = 7.5 Hz, 2H), 7.81 - 7.83 (m, 4H), 7.89 (d, *J*= 8.1 Hz, 2H), 9.69 (s, 2H).
**$^{13}$C-NMR** (126 MHz, $CDCl_3$, 298 K): δ/ppm = 67.2 ($CH_2$), 68.5 ($CH_2$), 69.2 ($CH_2$), 70.6 ($CH_2$), 83.7 (CH), 89.4 ($CH_2$), 120.2 (CH), 121.2 (CH), 123.0 (C), 123.9 (C), 124.2 (C), 124.4 (CH), 124.6 (CH), 125.5 (CH), 126.0 (CH), 126.9 (CH), 127.0 (CH), 128.2 (C), 129.7 (C), 130.3 (C), 130.8 (C), 156.5 (C), 167.8 (C).
**HR MS (ESI)** $[M+H]^+$ *m/z* calculated for $C_{48}H_{43}N_2O_8$ 775.3014, observed 775.3034.

**Optical rotation** ($CH_3CN$), $[\alpha]_D^{20} = -400$ (c = $8.74 \cdot 10^{-6}$ g/mL, first eluted enantiomer); $[\alpha]_D^{20} = +365$ (c = $6.03 \cdot 10^{-6}$ g/mL, second eluted enantiomer).
**Cotton effects** for (-)-pyrene-18C6 in $CH_3CN$, λ/nm (Δε/$M^{-1}cm^{-1}$): 383 (+3.6), 347 (-20.5), 274 (-12.4), 246 (-27.8).
**g factor** ($CH_3CN$), λ = 490 nm: $+0.9 \cdot 10^{-2}$ ((-)-pyrene-18C6); $-0.88 \cdot 10^{-2}$ ((+)-pyrene-18C6).

## Pyrene-18C4

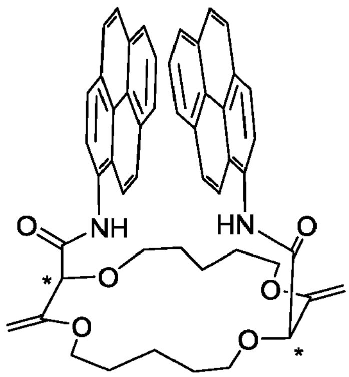

**Purification conditions:**

Column 1 eluent ($SiO_2$): pure EtOAc then $CH_2Cl_2$/methanol gradient (99:1, 97:3).
Column 2 eluent ($Al_2O_3$, neutral): EtOAc/pentane gradient (2:8, 3:7, 5:5, 1:0) then $CH_2Cl_2$/methanol (99:1).
Precipitation: EtOAc then pentane
**Yield:** 70%, off white solid
**CSP-HPLC:** semi-preparative IG, $CH_2Cl_2$ (+0.1% $Et_2NH$)/$CH_3CN$ (+0.1% $Et_2NH$) = 7:3, 2 mL/min, 20 °C
**$^1$H-NMR** (500 MHz, $CDCl_3$, 298 K): δ/ppm = 1.51 - 1.60 (m, 2H), 1.75 - 1.90 (m, 4H), 2.01 - 2.16 (m, 4H), 2.42 - 2.51 (m, 2H), 3.68 - 3.73 (m, 6H), 3.99 - 4.02 (m, 2H), 4.37 (d, *J* = 2.5 Hz, 2H), 4.43 (d, *J* = 2.5 Hz, 2H), 4.47 (s, 2H), 6.92 (d, *J* = 8.1 Hz, 2H), 7.07 (d, *J* = 8.0 Hz, 2H), 7.31 (d, *J* = 8.8 Hz, 2H), 7.63 (d, *J* = 8.8 Hz, 2H), 7.72 (q, *J* = 9.1 Hz, 4H), 7.82 - 7.88 (m, 4H), 7.95 (dd, *J* = 7.3, 1.3 Hz, 2H), 8.65 (s, 2H).
**$^{13}$C-NMR** (126 MHz, $CDCl_3$, 298 K): δ/ppm = 25.1 ($CH_2$), 29.7 ($CH_2$), 31.2 ($CH_2$), 68.4 ($CH_2$), 68.6 ($CH_2$), 83.2 (CH), 89.3 ($CH_2$), 119.8 (CH), 122.1 (CH), 123.6 (C), 123.9 (CH), 123.9 (C), 124.0 (C), 124.86 (CH), 124.94 (CH), 125.6 (CH), 126.0 (CH), 127.0 (CH), 127.2 (CH), 128.3 (C), 128.5 (C), 130.2 (C), 130.7 (C), 156.4 (C), 167.8 (C).
**HR MS (ESI)** $[M+H]^+$ m/z calculated for $C_{50}H_{47}N_2O_6$ 771.3429, observed 771.3429. **Optical rotation** ($CHCl_3$), $[\alpha]_D^{20} = -275$ (c = $1.6 \cdot 10^{-4}$ g/mL, first eluted enantiomer); $[\alpha]_D^{20} = +223$ (c = $1.2 \cdot 10^{-4}$ g/mL, second eluted enantiomer).
**Cotton effects** for (-)-pyrene-18C4 in $CH_2Cl_2$, λ/nm (Δε/$M^{-1}cm^{-1}$): 347 (-35.1), 274 (+27.9), 250 (-70.5).
**g factor** ($CH_2Cl_2$), λ = 481 nm: $-1.0 \cdot 10^{-2}$ ((-)-pyrene-18C4); $+0.99 \cdot 10^{-2}$ ((+)-pyrene-18C4).

## Pyrene-16C4

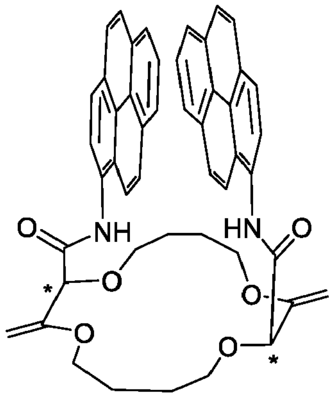

**Purification conditions:**

Column 1 eluent ($SiO_2$): EtOAc/pentane gradient (5:5, 7:3, 1:0) then $CH_2Cl_2$/methanol (99:1).
Column 2 eluent ($Al_2O_3$, neutral): pure EtOAc then $CH_2Cl_2$/methanol (99:1).
Precipitation: EtOAc then pentane
**Yield:** 80%, off white solid
**CSP-HPLC:** semi-preparative IG, $CH_2Cl_2$ (+0.1% $Et_2NH$)/$CH_3CN$ (+0.1% $Et_2NH$) = 7:3, 3 mL/min, 20 °C
**$^1$H-NMR** (400 MHz, $CDCl_3$, 298 K): δ/ppm = 1.80 - 1.96 (m, 4H), 2.14 - 2.26 (m, 4H), 3.66 - 3.80 (m, 6H), 3.92 - 3.97 (m, 2H), 4.45 (d, *J* = 2.5 Hz, 2H), 4.52 (d, *J* = 2.4 Hz, 2H), 4.54 (s, 2H), 7.87 - 8.01 (m, 10H), 8.07 - 8.15 (m, 6H), 8.60 (d, *J*= 8.3 Hz, 2H), 9.35 (s, 2H).
**$^{13}$C-NMR** (101 MHz, $CDCl_3$, 298 K): δ/ppm = 24.4 ($CH_2$), 25.6 ($CH_2$), 66.3 ($CH_2$), 67.2 ($CH_2$), 82.7 (CH), 89.7 ($CH_2$), 119.9 (CH), 121.3 (CH), 123.0 (C), 124.8 (C), 125.1 (CH), 125.2 (C), 125.45 (CH), 125.49 (CH), 126.2 (CH), 126.8 (CH), 127.5 (CH), 128.0 (CH), 129.0 (C), 130.1 (C), 130.8 (C), 131.4 (C), 156.5 (C), 167.5 (C).
**HR MS (ESI)** $[M+H]^+$ m/z calculated for $C_{48}H_{43}N_2O_6$ 743.3116, observed 743.3128. **Optical rotation** ($CHCl_3$), $[\alpha]_D^{20} = -144$ (c = $1.0\cdot10^{-4}$ g/mL, first eluted enantiomer); $[\alpha]_D^{20} = +112$ (c = $1.3\cdot10^{-4}$ g/mL, second eluted enantiomer).
**Cotton effects** for (-)-pyrene-16C4 in $CH_2Cl_2$, $\lambda$/nm ($\Delta\varepsilon/M^{-1}cm^{-1}$): 367 (-5.5), 339 (-5.9), 284 (+12.8), 276 (+6.1), 244 (-18.1).
**g factor** ($CH_2Cl_2$), $\lambda$ = 491 nm: $+1.7\cdot10^{-2}$ ((-)-pyrene-16C4); $-1.8\cdot10^{-2}$ ((+)-pyrene-16C4).

## Fluorene-18C6

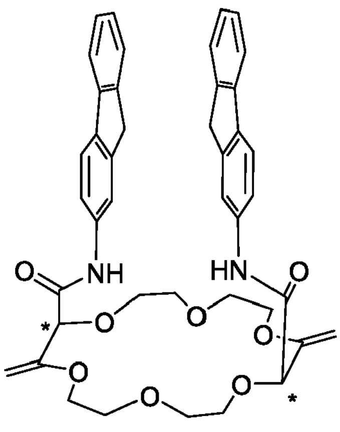

**Purification conditions:**

Column eluent ($SiO_2$): $CH_2Cl_2$/methanol gradient (100:0, 95:5, 90:10).
Precipitation: $CH_2Cl_2$ then pentane
**Yield:** 38%, yellow solid
**CSP-HPLC:** semi-preparative IG, $CH_2Cl_2$ (+0.1% $Et_2NH$)/$CH_3CN$ (+0.1% $Et_2NH$) = 7:3, 2 mL/min, 20 °C
**$^1$H-NMR** (500 MHz, $CDCl_3$, 298 K): δ/ppm = 3.58 - 3.66 (m, 5H), 3.67 - 3.76 (m, 5H), 3.79 - 3.83 (m, 2H), 3.87 - 3.96 (m, 6H), 4.02 - 4.07 (m, 2H), 4.33 (d, 2H, *J* = 2.7 Hz), 4.39 (s, 2H), 4.49 (d, 2H, *J* = 2.7 Hz), 7.15 - 7.22 (m, 4H), 7.34 - 7.36 (m, 2H), 7.44 7.46 (m, 4H), 7.50 - 7.52 (m, 2H), 7.94 (s, 2H), 9.52 (s, 2H).
**$^{13}$C-NMR** (126 MHz, $CDCl_3$, 298 K): δ/ppm = 37.1 ($CH_2$), 66.9 ($CH_2$), 68.7 ($CH_2$), 69.2 ($CH_2$), 70.2 ($CH_2$), 83.4 (CH), 88.7 ($CH_2$), 116.6 (CH), 118.6 (CH), 119.5 (CH), 120.1 (CH), 124.9 (CH), 126.1 (CH), 126.7 (CH), 137.0 (C), 137.9 (C), 141.4 (C), 143.3 (C), 144.2 (C), 156.7 (C), 167.3 (C).
**HR MS (ESI)** $[M+H]^+$ m/z calculated for $C_{42}H_{43}N_2O_8$ 703.3014, observed 703.3029 (2.1 ppm).
Optical rotation ($CHCl_3$), $[\alpha]_D^{20} = -37$ (c = $7.0 \cdot 10^{-5}$ g/mL, first eluted enantiomer); $[\alpha]_D^{20} = +31$ (c = $7.0 \cdot 10^{-5}$ g/mL, second eluted enantiomer).
**Cotton effects** for (-)-fluorene-18C6 in $CH_3CN$, $\lambda$/nm ($\Delta\varepsilon$/$M^{-1}cm^{-1}$): 319 (-9.0), 275 (+7.9).

**NMI-18C6**

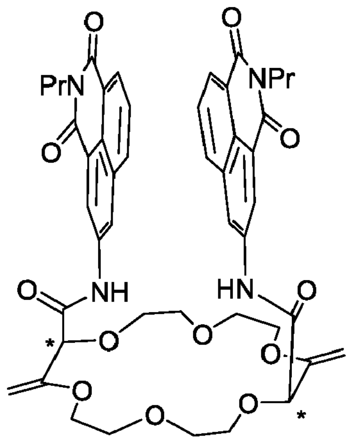

**Purification conditions:**

Column 1 eluent ($SiO_2$): $CH_2Cl_2$, then $CH_2Cl_2$/methanol gradient (98:2, 95:5, 90:10).
Column 2 eluent ($Al_2O_3$, neutral): $CH_2Cl_2$ for the packing of the column, then $CH_2Cl_2$/methanol gradient (99:1, 98:2, 97:3).
Preparative TLC ($SiO_2$): $CH_2Cl_2$/methanol (95:5)
**Yield:** 17%, yellow solid
**CSP-HPLC:** semi-preparative IG, $CH_2Cl_2$ (+0.1% $Et_2NH$)/$CH_3CN$ (+0.1% $Et_2NH$) = 9:1, 2 mL/min, 20 °C
**$^1$H-NMR** (500 MHz, $CDCl_3$, 298 K): δ/ppm = 0.92 (t, 6H, *J* = 7.4 Hz), 1.54 - 1.62 (m, 4H), 3.64 - 3.69 (m, 4H), 3.73 - 3.77 (m, 2H), 3.82 - 3.98 (m, 8H), 4.04 - 4.07 (m, 2H), 4.13 - 4.23 (m, 4H), 4.40 (d, 2H, *J* = 2.8 Hz), 4.41 (s, 2H), 4.51 (d, 2H, *J* = 2.8 Hz), 7.48 (dd, 2H, *J* = 8.3 Hz, 7.2 Hz), 7.79 (dd, 2H, *J* = 8.3 Hz, 1.1 Hz), 8.13 (d, 2H, *J* = 2.1 Hz), 8.16 (dd, 2H, *J* = 7.2 Hz, 1.1 Hz), 8.67 (d, 2H, *J*= 2.1 Hz), 9.85 (s, 2H).
**$^{13}$C-NMR** (126 MHz, $CDCl_3$, 298 K): δ/ppm = 11.5 ($CH_3$), 21.2 ($CH_2$), 41.8 ($CH_2$), 65.7 ($CH_2$), 68.7 ($CH_2$), 69.0 ($CH_2$), 69.1 ($CH_2$), 83.1 (CH), 88.9 ($CH_2$), 121.4 (CH), 121.8 (C), 122.7 (C), 123.8 (CH), 124.4 (C), 126.9 (CH), 129.4 (CH), 131.9 (C), 133.2 (CH), 136.5 (C), 156.5 (C), 163.0 (C), 163.6 (C), 168.0 (C).
**HR MS (ESI)** $[M+H]^+$ *m/z* calculated for $C_{46}H_{49}N_4O_{12}$ 849.3342, observed 849.3340 (-0.2 ppm).

**Optical rotation** ($CH_3CN$), $[\alpha]_D^{20} = -64$ (c = $1.40 \cdot 10^{-4}$ g/mL, first eluted enantiomer); $[\alpha]_D^{20} = +43$ (c = $1.02 \cdot 10^{-4}$ g/mL, second eluted enantiomer).
**Cotton effects** for (-)-NMI-18C6 in $CH_3CN$, $\lambda$/nm ($\Delta\varepsilon$/$M^{-1}cm^{-1}$): 397 (+4.3), 332 (-4.7), 275 (-24.7), 250 (+88.0).
**g factor** ($CH_3CN$), $\lambda$ = 485 nm: $+0.82 \cdot 10^{-2}$ ((-)-NMI-18C6); $-0.86 \cdot 10^{-2}$ ((+)-NMI-18C6).

## Perylene-18C6

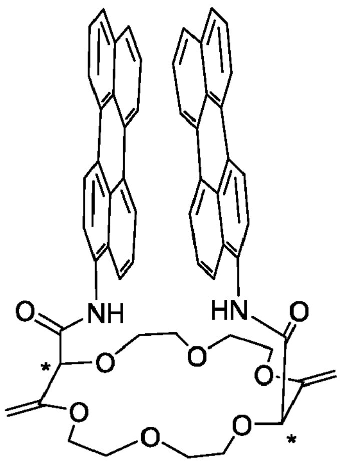

**Purification conditions:**

Column eluent ($SiO_2$): $CH_2Cl_2$, then $CH_2Cl_2$/methanol gradient (98:2, 95:5, 90:10).
Precipitation: $CH_2Cl_2$ then pentane
**Yield:** 60%, yellow-orange solid
**CSP-HPLC:** semi-preparative IG, $CH_2Cl_2$ (+0.1% $Et_2NH$)/$CH_3CN$ (+0.1% $Et_2NH$) = 9:1, 3 mL/min, 20 °C
**$^1$H-NMR** (500 MHz, $CDCl_3$, 298 K): $\delta$/ppm = 3.72 (m, 2H), 3.80 (m, 2H), 3.88 (m, 2H), 3.95-4.05 (m, 6H), 4.08 (m, 4H), 4.41 (d, 2H, *J* = 2.6 Hz), 4.47 (s, 2H), 4.52 (d, 2H, *J*= 2.6 Hz), 7.08 (m, 6H), 7.29 (t, 4H, *J*= 8.3 Hz), 7.50 (t, 4H, *J*= 8.3 Hz), 7.55 (d, 2H, *J*= 7.4 Hz), 7.62 (d, 2H, *J* = 7.4 Hz), 7.71 (d, 2H, *J* = 8.2 Hz), 7.82 (d, 2H, *J* = 8.2 Hz), 9.27 (s, 2H).
**$^{13}$C-NMR** (126 MHz, $CDCl_3$, 298 K): $\delta$/ppm = 67.3 ($CH_2$), 68.6 ($CH_2$), 68.9 ($CH_2$), 70.4 ($CH_2$), 83.5 (CH), 89.7 ($CH_2$), 119.5 (CH), 119.6 (CH), 119.7 (CH), 119.9 (CH), 120.1 (CH), 126.0 (CH), 126.1 (CH), 126.2 (CH), 127.0 (CH), 127.3 (CH), 127.4 (C), 127.8 (C), 128.3 (C), 128.5 (C), 130.46 (C), 130.49 (C), 131.0 (C), 131.5 (C), 134.2 (C), 156.3 (C), 167.3 (C).
**HR MS (ESI)** $[M+H]^+$ m/z calculated for $C_{56}H_{47}N_2O_8$ 875.3327, observed 875.3341 (1.6 ppm).
**Optical rotation** ($CHCl_3$), $[\alpha]_D^{20} = -184$ (c = $2.5 \cdot 10^{-4}$ g/mL, first eluted enantiomer); $[\alpha]_D^{20} = +163$ (c = $2.0 \cdot 10^{-4}$ g/mL, second eluted enantiomer).
**Cotton effects** for (-)-perylene-18C6 in $CH_3CN$, $\lambda$/nm ($\Delta\varepsilon$/$M^{-1}cm^{-1}$): 456 (+17.1), 413 (-13.4), 308 (-8.2), 260 (+7.8).
**g factor** ($CH_3CN$), $\lambda$ = 543 nm: $+0.3 \cdot 10^{-2}$ ((-)-perylene-18C6); $-0.3 \cdot 10^{-2}$ ((+)-perylene-18C6).

## Perylene-18C4

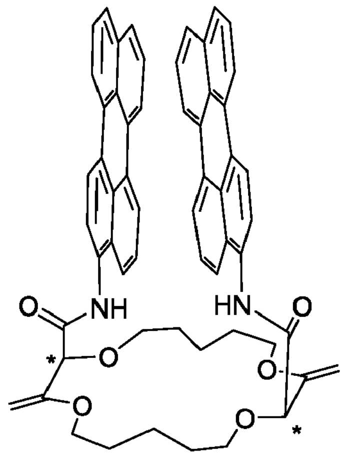

**Purification conditions:**

Column 1 eluent ($SiO_2$): $CH_2Cl_2$, then $CH_2Cl_2$/methanol gradient (99:1, 98:2, 96:4).
Column 2 eluent ($SiO_2$): $CH_2Cl_2$, then $CH_2Cl_2$/methanol gradient (99.5:0.5, 99:1, 98:2).
Precipitation: $CH_2Cl_2$ then pentane
**Yield:** 51%, yellow-brown solid
**CSP-HPLC:** semi-preparative IG, $CH_2Cl_2$ (+0.1% $Et_2NH$)/$CH_3CN$ (+0.1% $Et_2NH$) = 8:2, 3 mL/min, 20 °C
**$^1$H-NMR** (500 MHz, $CDCl_3$, 298 K): $\delta$/ppm = 1.54 (m, 2H), 1.76 (m, 2H), 1.84 (m, 2H), 1.97 - 2.07 (m, 4H), 2.40 (m, 2H), 3.62 - 3.74 (m, 6H), 4.02 (dt, *J* = 8.4, 3.8 Hz, 2H), 4.37 (d, *J* = 2.4 Hz, 2H), 4.41 - 4.43 (m, 4H), 6.98 (d, *J*= 7.7 Hz, 2H), 7.18 (d, *J*= 7.4 Hz, 2H), 7.23 (m, 2H), 7.30 - 7.33 (m, 4H), 7.36 (d, *J*= 8.1 Hz, 2H), 7.40 (d, *J*= 8.1 Hz, 2H), 7.43 - 7.47 (m, 4H), 7.64 (d, *J*= 7.3 Hz, 2H), 7.81 (d, *J*= 7.4 Hz, 2H), 8.37 (s, 2H).
**$^{13}$C-NMR** (126 MHz, $CDCl_3$, 298 K): $\delta$/ppm = 25.2 ($CH_2$), 29.8 ($CH_2$), 31.2 ($CH_2$), 68.5 ($CH_2$), 68.6 ($CH_2$), 83.3 (CH), 89.4 ($CH_2$), 119.5 (CH), 119.7 (CH), 120.0 (CH), 120.2 (CH), 122.3 (CH), 126.0 (CH), 126.1 (CH), 126.2 (CH), 127.1 (CH), 127.75 (CH), 127.82 (C), 128.5 (C), 128.6 (C), 128.9 (C), 130.2 (C), 130.7 (C), 130.8 (C), 131.4 (C), 134.2 (C), 156.3 (C), 167.5 (C).
**HR MS (ESI)** $[M+H]^+$ m/z calculated for $C_{58}H_{51}N_2O_6$ 871.3742, observed 871.3758 (1.8 ppm).
**Optical rotation** ($CH_2Cl_2$), $[\alpha]_D^{20} = +133$ (c = $4.50 \cdot 10^{-5}$ g/mL, first eluted enantiomer); $[\alpha]_D^{20} = -98$ (c = $3.47 \cdot 10^{-5}$ g/mL, second eluted enantiomer).
**Cotton effects** for (+)-perylene-18C4 in $CH_2Cl_2$, $\lambda$/nm ($\Delta\varepsilon$/$M^{-1}cm^{-1}$): 459 (+24.2), 417 (-25.4), 311 (-12.1), 263 (+7.1).
**g factor** ($CH_2Cl_2$), $\lambda$ = 536 nm: $+0.6 \cdot 10^{-2}$ ((+)-perylene-18C4); $-0.6 \cdot 10^{-2}$ ((-)-perylene-18C4).

## Perylene-16C4

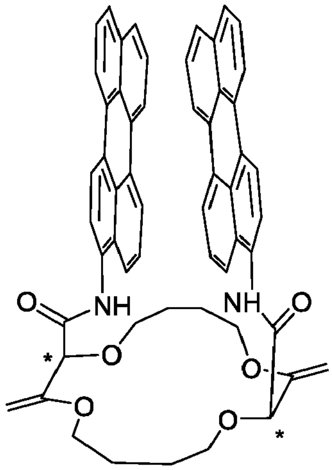

**Purification conditions:**

Column 1 eluent ($SiO_2$): $CH_2Cl_2$, then $CH_2Cl_2$/methanol gradient (98:2, 95:5, 90:10).
Column 2 eluent ($SiO_2$): $CH_2Cl_2$, then $CH_2Cl_2$/EtOAc gradient (98:2, 96:4, 94:6, 92:8).
Precipitation: $CH_2Cl_2$ then pentane
**Yield:** 52%, greenish-brown solid
**CSP-HPLC:** semi-preparative IG, $CH_2Cl_2$ (+0.1% $Et_2NH$)/$CH_3CN$ (+0.1% $Et_2NH$) = 8:2, 3 mL/min, 20 °C
**$^1$H-NMR** (500 MHz, $CDCl_3$, 298 K): δ/ppm = 1.79 - 1.90 (m, 4H), 2.06 - 2.17 (m, 4H), 3.64 (m, 2H), 3.70 - 3.74 (m, 4H), 3.93 (m, 2H), 4.42 (d, *J* = 2.4 Hz, 2H), 4.46 (s, 2H), 4.48 (d, *J* = 2.4 Hz, 2H), 7.37 - 7.44 (m, 6H), 7.60-7.67 (m, 6H), 8.02 - 8.10 (m, 6H), 8.15 (s, 4H), 9.06 (s, 2H).
**$^{13}$C-NMR** (126 MHz, $CDCl_3$, 298 K): δ/ppm = 24.5 ($CH_2$), 25.8 ($CH_2$), 66.5 ($CH_2$), 67.2 ($CH_2$), 82.7 (CH), 89.7 ($CH_2$), 119.8 (CH), 120.1 (CH), 120.2 (CH), 120.5 (CH), 120.6 (CH), 126.6 (CH), 126.8 (CH), 126.9 (CH), 127.6 (CH), 128.2 (CH + C), 128.5 (C), 128.6 (C), 129.3 (C), 131.0 (C), 131.1 (C), 131.6 (C), 132.1 (C), 134.7 (C), 156.5 (C), 167.2 (C).
**HR MS (ESI)** $[M+H]^+$ m/z calculated for $C_{56}H_{47}N_2O_6$ 843.3429, observed 843.3423 (-0.6 ppm).
**Optical rotation** ($CH_2Cl_2$), $[\alpha]_D^{20} = +271$ (c = $4.06\cdot10^{-6}$ g/mL, first eluted enantiomer); $[\alpha]_D^{20} = -316$ (c = $6.63\cdot10^{-6}$ g/mL, second eluted enantiomer).
**Cotton effects** for (+)-perylene-16C4 in $CH_2Cl_2$, λ/nm (Δε/$M^{-1}cm^{-1}$): 460 (+18.2), 416 (-7.3), 301 (-8.8).
g **factor** ($CH_2Cl_2$), λ = 544 nm: $-0.4\cdot10^{-2}$ ((+)-perylene-16C4); $+0.4\cdot10^{-2}$ ((-)-perylene-16C4).

## Fluorene-18C4

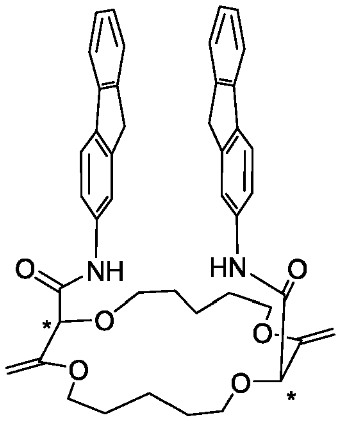

**Purification conditions:**

Column eluent ($SiO_2$): ethyl acetate (remaining aniline co-eluted with fluorene-18C4) Precipitation: ethyl acetate then pentane (this step was repeated twice)

**Yield:** 19%, yellow solid

**CSP-HPLC:** semi-preparative IG, $CH_2Cl_2$ (+0.1% $Et_2NH$)/$CH_3CN$ (+0.1% $Et_2NH$) = 7:3, 3 mL/min, 20 °C

**$^1$H-NMR** (500 MHz, $CDCl_3$, 298 K): δ/ppm = 1.66 - 1.84 (m, 12H), 3.52 - 3.78 (m, 10H), 3.88 - 3.92 (m, 2H), 4.27 (s, 2H), 4.33 (d, 2H, *J* = 2.4 Hz), 4.36 (d, 2H, *J* = 2.4 Hz), 7.21 - 7.26 (m, 4H), 7.32 - 7.34 (m, 2H), 7.40 - 7.42 (m, 2H), 7.48 - 7.46 (m, 2H), 7.51 - 7.53 (m, 2H), 7.90 (s, 2H), 8.53 (s, 2H).

**$^{13}$C-NMR** (126 MHz, $CDCl_3$, 298 K): δ/ppm = 24.4 ($CH_2$), 28.8 ($CH_2$), 30.0 ($CH_2$), 37.1 ($CH_2$), 68.2 ($CH_2$), 69.7 ($CH_2$), 82.9 (CH), 88.5 ($CH_2$), 116.7 (CH), 118.5 (CH), 119.7 (CH), 120.3 (CH), 125.0 (CH), 126.4 (CH), 126.8 (CH), 136.3 (C), 138.2 (C), 141.3 (C), 143.3 (C), 144.5 (C), 156.9 (C), 167.3 (C).

**HR MS (ESI)** $[M+H]^+$ m/z calculated for $C_{44}H_{47}N_2O_6$ 699.3429, observed 699.3439 (1.4 ppm).

**Optical rotation** ($CHCl_3$), $[\alpha]_D^{20} = -23$ (c = $3.5 \cdot 10^{-4}$ g/mL, first eluted enantiomer); $[\alpha]_D^{20} = +20$ (c = $2.5 \cdot 10^{-4}$ g/mL, second eluted enantiomer).

**Cotton effects** for (-)-fluorene-18C4 in $CH_2Cl_2$, $\lambda$/nm ($\Delta\varepsilon$/$M^{-1}cm^{-1}$): 322 (-1.2), 275 (+1.1).

## Fluorene-16C4

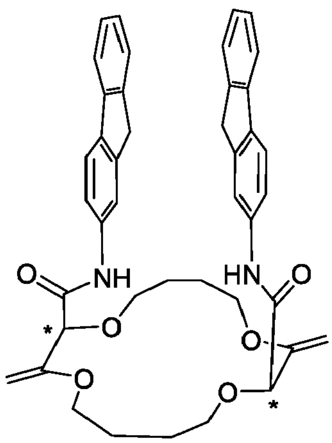

**Purification conditions:**

Column eluent ($SiO_2$): ethyl acetate (remaining aniline co-eluted with fluorene-16C4)
Precipitation: ethyl acetate the pentane (this step was repeated twice)
**Yield:** 35%, yellow solid
**CSP-HPLC:** semi-preparative IG, $CH_2Cl_2$ (+0.1% $Et_2NH$)/$CH_3CN$ (+0.1% $Et_2NH$) = 8:2, 3 mL/min, 20 °C
**$^1$H-NMR** (500 MHz, $CDCl_3$, 298 K): δ/ppm = 1.69 - 1.75 (m, 4H), 1.94 - 2.01 (m, 4H), 3.53 - 3.66 (m, 6H), 3.80 - 3.89 (m, 6H), 4.30 (s, 2H), 4.35 (d, 2H, *J* = 2.4 Hz), 4.39 (d, 2H, *J* = 2.4 Hz), 7.26 - 7.29 (m, 2H), 7.34 - 7.37 (m, 2H), 7.47 - 7.53 (m, 4H), 7.71 - 7.73 (m, 4H), 7.98 (s, 2H), 8.59 (s, 2H).
**$^{13}$C-NMR** (126 MHz, $CDCl_3$, 298 K): δ/ppm = 24.2 ($CH_2$), 25.5 ($CH_2$), 37.2 ($CH_2$), 66.4 ($CH_2$), 67.6 ($CH_2$), 82.3 (CH), 89.3 ($CH_2$), 116.7 (CH), 118.6 (CH), 119.7 (CH), 120.2 (CH), 125.1 (CH), 126.5 (CH), 126.9 (CH), 136.4 (C), 138.3 (C), 141.5 (C), 143.3 (C), 144.5 (C), 156.6 (C), 166.9 (C).
**HR MS (ESI)** $[M+H]^+$ m/z calculated for $C_{42}H_{43}N_2O_6$ 671.3116, observed 671.3116 (0.1 ppm).
**Optical rotation** ($CHCl_3$), $[\alpha]_D^{20} = +17$ (c = 1.2·10$^{-4}$ g/mL, first eluted enantiomer); $[\alpha]_D^{20} = -15$ (c = 1.3·10$^{-4}$ g/mL, second eluted enantiomer).
**Cotton effects** for (+)-fluorene-16C4 in $CH_2Cl_2$, λ/nm (Δε/$M^{-1}cm^{-1}$): 316 (+7.1), 271 (-4.1).

**Perylene-pyrene-18C6**

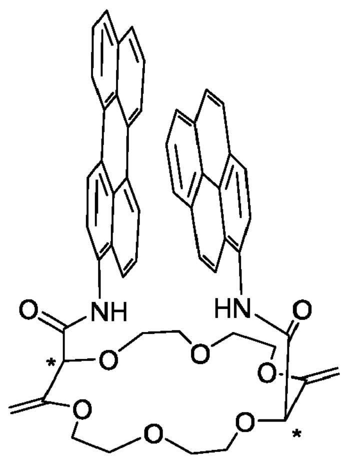

**Purification conditions:**

Column eluent ($SiO_2$): $CH_2Cl_2$, then $CH_2Cl_2$/Methanol gradient (98:2, 95:5, 90:10). Then CSP-HPLC (see below).
Precipitation: $CH_2Cl_2$ then pentane
**Yield:** 13%, yellow-orange solid
**CSP-HPLC:** semi-preparative IG, $CH_2Cl_2$ (+0.1% $Et_2NH$)/$CH_3CN$ (+0.1% $Et_2NH$) = 9:1, 3 mL/min, 20 °C
**$^1$H-NMR** (500 MHz, $CDCl_3$): δ/ppm = 3.66 (br s, 2H), 3.72 - 3.94 (m, 6H), 3.94 - 4.17 (m, 8H), 4.42 (dd, 2H, *J* = 6.7, 2.6 Hz), 4.48 - 4.58 (m, 4H), 6.95 (t, 1H, *J* = 7.9 Hz), 7.16 - 7.38 (m, 6H), 7.43 - 7.76 (m, 11H), 7.81 (d, 1H, *J* = 9.1 Hz), 8.35 (d, 1H, *J* = 8.35 Hz), 9.27 (s, 1H), 9.48 (s, 1H).
**$^{13}$C-NMR** (126 MHz, $CDCl_3$): δ/ppm = 67.1 ($CH_2$), 67.4 ($CH_2$), 68.6 ($CH_2$), 68.7 ($CH_2$), 68.9 ($CH_2$), 70.4 ($CH_2$), 70.5 ($CH_2$), 70.6 ($CH_2$), 83.5 (CH), 89.6 ($CH_2$), 89.7 ($CH_2$), 119.3 (CH), 119.5 (CH), 119.6 (CH), 119.7 (CH), 119.8 (CH), 119.9 (CH), 120.8 (CH), 122.6 (CH), 124.1 (CH), 124.5 (CH), 124.6 (CH), 124.8 (2 CH), 125.5 (CH), 125.9 (CH), 126.0 (CH), 126.2 (CH), 126.3 (CH), 126.5 (CH), 127.0 (C), 127.3(C), 127.5 (C), 127.9 (C), 128.1 (C), 128.6 (C), 129.9 (C), 130.4 (C), 130.7 (C), 130.9 (C), 131.3 (C), 134.4 (C), 156.4 (C), 165.5 (C), 167.4 (C).
**HR MS (ESI)** $[M+H]^+$ m/z calculated for $C_{52}H_{45}N_2O_8$ 825.3170, observed 825.3189 (2.3 ppm).

**Optical rotation** ($CHCl_3$), $[\alpha]_D^{20} = -76$ (c = 1.4·$10^{-4}$ g/mL, first eluted enantiomer); $[\alpha]_D^{20} = +77$ (c = 1.5·$10^{-4}$ g/mL, second eluted enantiomer);
**Cotton effects** for (-)-perylene-pyrene-18C6 in $CH_3CN$, $\lambda$/nm ($\Delta\varepsilon$/$M^{-1}cm^{-1}$): 442 (+1.3), 420 (+1.2), 386 (-0.5), 300 (-4.4), 245 (-7.7).

**Pyrene-18C6-$H_2$**

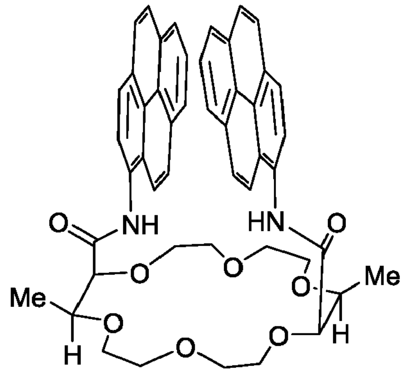

To a solution of **pyrene-18C6** (20 mg, 0.025 mmol, 1 equiv) in dry THF (1.5 mL) was added $PtO_2$ (0.6 mg, 2.5 $\mu$mol, 10 mol %). The mixture was stirred under $H_2$ atmosphere (1 atm) for 16 hours and then concentrated under vacuum. Purification by silica gel preparative TLC ($CH_2Cl_2$/MeOH = 9:1) afforded the *cis,cis* hydrogenated macrocycle (16 mg, 82% yield) as a beige oil.

**$^1$H-NMR** (500 MHz, $CDCl_3$, 298 K): $\delta$/ppm = 1.25 (d, *J*= 6.6 Hz, 6H), 3.76 (m, 2H), 3.81 - 3.96 (m, 10H), 4.00 (m, 2H), 4.05 - 4.13 (m, 4H), 4.34 (d, *J* = 2.4 Hz, 2H), 7.88 - 7.95 (m, 8H), 7.98 (d, *J* = 8.2 Hz, 2H), 8.02 (d, *J* = 7.5 Hz, 2H), 8.08 (d, *J* = 7.5 Hz, 2H), 8.13 (d, *J* = 9.2 Hz, 2H), 8.34 (d, *J* = 8.2 Hz, 2H), 9.59 (s, 2H).
**$^{13}$C-NMR** (126 MHz, $CDCl_3$, 298 K): $\delta$/ppm = 15.3 ($CH_3$), 69.4 ($CH_2$), 70.8 ($CH_2$), 70.9 ($CH_2$), 71.2 ($CH_2$), 77.5 (CH), 84.2 (CH), 120.9 (CH), 121.6 (CH), 123.4 (C), 124.7 (C), 124.9 (CH), 125.1 (C), 125.2 (CH), 125.3 (CH), 126.0 (CH), 126.7 (CH), 127.4 (CH), 127.6 (CH), 128.9 (C), 130.4 (C), 130.8 (C), 131.3 (C), 169.3 (C).
**HR MS (ESI)** $[M+H]^+$ *m/z* calculated for $C_{48}H_{47}N_2O_8$ 779.3327, observed 779.3330 (0.4 ppm).

**Procedure for the thiol-ene reaction**

To a suspension of **pyrene-18C6** (40 mg, 0.05 mL, 1 equiv) in dry and degassed THF (2 mL) were added 2,2-dimethoxyphenylacetophenone (2.6 mg, 0.2 equiv) and ethanedithiol (42 $\mu$L, 10 equiv). The mixture was stirred under high pressure mercury lamp irradiation for 16 hours, and then purified by column chromatography on silica gel ($CH_2Cl_2$ to $CH_2Cl_2$/MeOH = 98:2) to afford a mixture of the two diastereomers in a 1:0.6 ratio. Further purification of this mixture by silica gel preparative TLC ($CH_2Cl_2$/MeOH = 97:3) afforded *cis,cis*-pyrene-18C6-$SCH_2CH_2SH$ (18 mg, 37%) and *cis,trans*-pyrene-18C6-$SCH_2CH_2SH$ (8 mg, 17%) as yellow solids.

***cis,cis*-Pyrene-18C6-$SCH_2CH_2SH$**

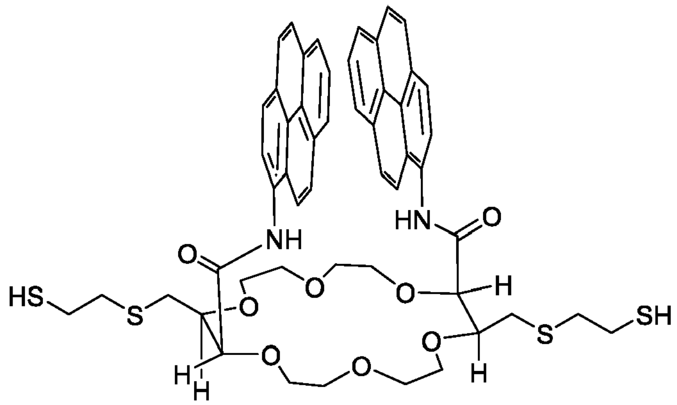

**$^1$H-NMR** (500 MHz, $CDCl_3$, 298 K): δ/ppm = 1.62 (t, $J$ = 8.0 Hz, 2H), 2.59 - 2.64 (m, 4H), 2.67 - 2.78 (m, 8H), 3.76 (m, 2H), 3.82 (m, 2H), 3.89 - 4.04 (m, 12H), 4.07 (ddd, $J$ = 11.2, 8.2, 2.7 Hz, 2H), 4.48 (d, $J$ = 1.7 Hz, 2H), 7.89 - 7.96 (m, 10H), 8.06 (d, $J$ = 7.4 Hz, 2H), 8.11 (d, $J$ = 8.2 Hz, 2H), 8.12 (d, $J$ = 8.2 Hz, 2H), 8.19 (d, $J$ = 8.2 Hz, 2H), 9.68 (s, 2H).
**$^{13}$C-NMR** (126 MHz, $CDCl_3$, 298 K): δ/ppm = 24.8 ($CH_2$), 32.2 (CH), 37.2 ($CH_2$), 70.8 ($CH_2$), 71.1 ($CH_2$), 71.2 ($CH_2$), 71.5 ($CH_2$), 82.0 (CH), 82.9 (CH), 121.0 (CH), 121.8 (CH), 123.6 (C), 124.7 (C), 125.0 (CH), 125.11 (C), 125.13 (CH), 125.4 (CH), 126.1 (CH), 126.8 (CH), 127.4 (CH), 127.7 (CH), 129.1 (C), 130.2 (C), 130.8 (C), 131.4 (C), 168.9 (C).
**HR MS (ESI)** $[M+H]^+$ m/z calculated for $C_{52}H_{55}N_2O_8S_4$ 963.2836, observed 963.2873 (3.9 ppm).

***cis,trans*-Pyrene-18C6-$SCH_2CH_2SH$**

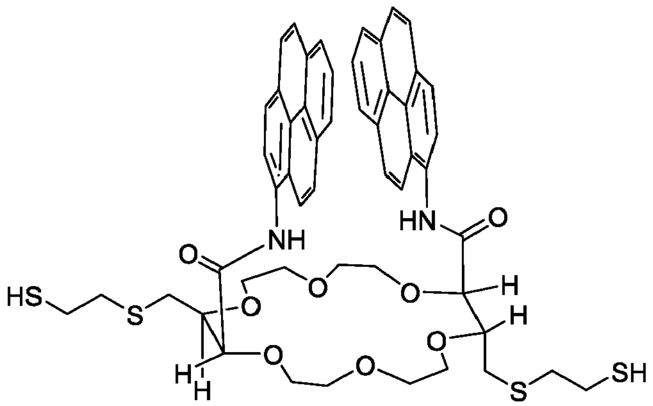

**$^1$H-NMR** (500 MHz, $CDCl_3$, 298 K): δ/ppm = 1.21 - 1.27 (m, 2H), 1.58 (m, 1H), 1.83 - 2.04 (m, 6H), 2.08 - 2.12 (m, 2H), 2.20 (t, $J$ = 10.9 Hz, 1H), 2.35 (ddd, $J$ = 28.1, 12.5, 4.1 Hz, 2H), 3.67 - 4.04 (m, 16H), 4.08 (m, 1H), 4.15 (m, 1H), 4.26 (d, $J$= 2.4 Hz, 1H), 4.40 (d, $J$ = 6.1 Hz, 1H), 7.95 - 8.19 (m, 14H), 8.31 (d, $J$ = 8.2 Hz, 1H), 8.37 - 8.45 (m, 3H), 9.55 (s, 1H), 9.97 (s, 1H).
**$^{13}$C-NMR** (126 MHz, $CDCl_3$, 298 K): δ/ppm = 24.2 ($CH_2$), 30.8 ($CH_2$), 33.4 ($CH_2$), 36.55 ($CH_2$), 36.64 ($CH_2$), 68.9 ($CH_2$), 69.3 ($CH_2$), 70.0 ($CH_2$), 70.3 ($CH_2$), 70.6 ($CH_2$), 71.0 ($CH_2$), 72.2 ($CH_2$), 72.8 ($CH_2$), 81.0 (CH), 81.2 (CH), 81.3 (CH), 81.9 (CH), 122.3 (CH), 122.4 (CH), 122.9 (CH), 123.4 (CH), 124.7 (C), 124.8 (C), 124.8 (C), 125.0 (CH), 125.08 (CH), 125.13 (CH), 125.18 (CH), 125.2 (C), 125.3 (C), 125.43 (C), 125.45 (CH), 125.6 (CH), 126.26 (CH), 126.34 (CH), 127.18 (CH), 127.21 (CH), 127.4 (CH), 127.6 (CH), 127.7 (CH), 129.4 (C), 129.5 (C), 130.76 (C), 130.82 (C), 130.9 (C), 131.1 (C), 131.4 (C), 170.0 (C), 170.6 (C).
**HR MS (ESI)** $[M+H]^+$ m/z calculated for $C_{52}H_{55}N_2O_8S_4$ 963.2836, observed 963.2867 (3.2 ppm).

## Switching procedure

CPL spectrum of a solution of the polyether macrocyclic compound of the invention (ca. $10^{-5}$ M) in $CH_2Cl_2$ or $CH_3CN$ is recorded. For the complexation experiments, either 2 equiv of $NaBAr_F$ or $Ba(ClO_4)_2$ from a $10^{-3}$ M solution in

$CH_2Cl_2$ or $CH_3CN$ respectively or an excess of the salt (neat) are added directly to the solution.

In the case of $NaBAr_F$ and $CH_2Cl_2$ conditions, the system can be switched back to the initial state by addition of an equimolar amount of 18-Crown-6 ($10^{-3}$ M $CH_2Cl_2$ solution) to the complex solution.

## Claims

1. A dextrorotatory and levorotatory enantioenriched functionalized polyether macrocyclic compound of formula (I)

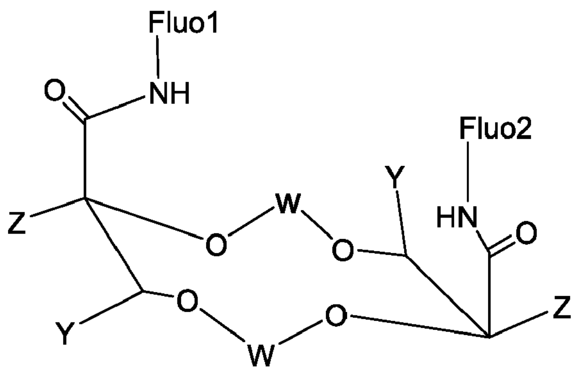

(I)

wherein

Fluol and Fluo2 are the same or different suitable fluorophores,
Y is selected from the group comprising $=CH_2$, $-CH_3$, $-CH_2$-A wherein A is selected from the group comprising -SH, -SR, heteroatoms selected from the group comprising S, N, O,
R is a functional group,
Z is H or halogen,
W is substituted or unsubstituted $C_4$-$C_6$-alkyl, wherein optionally at least one C atom is substituted by heteroatoms selected from the group comprising N, S and O, and wherein substituents are selected from the group comprising substituted or unsubstituted alkyl, substituted or unsubstituted heteroalkyl, substituted or unsubstituted aryl, substituted or unsubstituted heteroaryl, substituted or unsubstituted cycloalkyl, or substituted or unsubstituted heterocycloalkyl.

2. The compound of claim 1, wherein Fluol and Fluo2 are independently selected from the group comprising

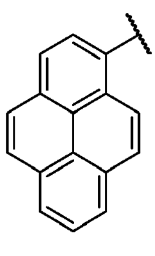
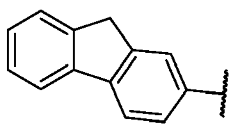
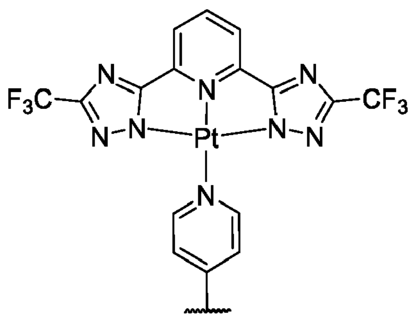
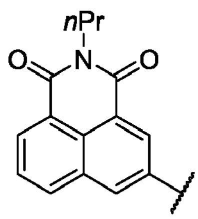

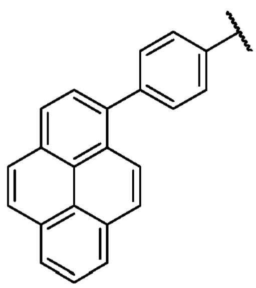

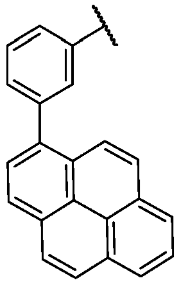

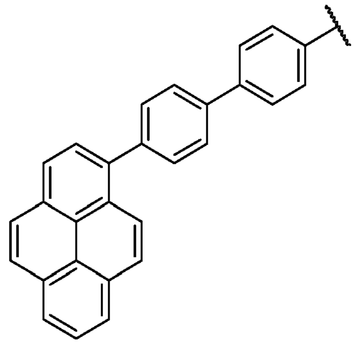

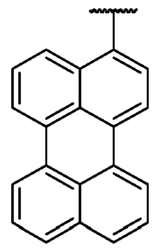

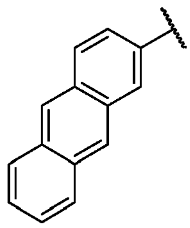

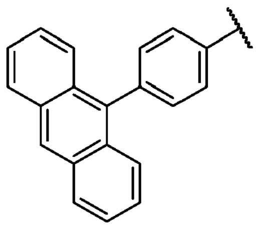

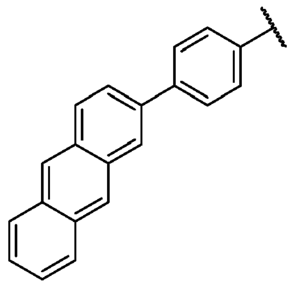

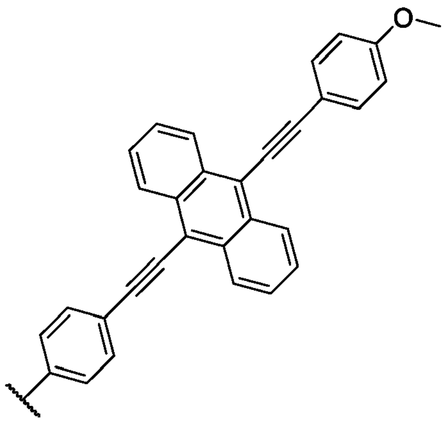

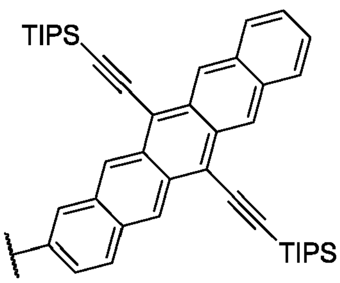

**3.** The compound of any one of claims 1-2, wherein R is the functional group selected from the group comprising alkyl group, aryl group, hydroxyl group, amino group, carbonyl group, carboxy group, thiol group, alkylthio group, amide group, and modified forms thereof.

**4.** The compound of any one of claims 1-3, wherein Z is H or F.

**5.** The compound of any one of claims 1-4, wherein W is selected from the group comprising $C_4$-alkyl, $C_5$-alkyl, $-(CH_2)_2-O-(CH_2)_2-$,$-(CH_2)_2-N-(CH_2)_2-$.

**6.** The compound of any one of claims 1-4, wherein W is unsubstituted $C_4$-$C_6$-alkyl and wherein at least one C atom is substituted by heteroatoms selected from the group comprising N and O.

**7.** The compound of claim 6, wherein one C atom is substituted by O.

**8.** The compound of any one of claims 1-7, wherein Z is -CH and Y is $=CH_2$.

**9.** The compound of any one of claims 1-2, wherein
Y is selected from the group comprising $=CH_2$, $-CH_3$, $-CH_2-S-(CH_2)_2-SH$,
Z is H or F,

W is is selected from the group comprising $C_4$-alkyl, $C_5$-alkyl, $-(CH_2)_2-O-(CH_2)_2-$,$-(CH_2)_2-N-(CH_2)_2-$.

**10.** The compound of claim 1 selected from the group comprising

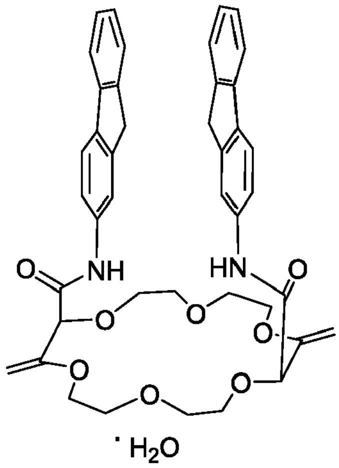

Fluorene-18C6

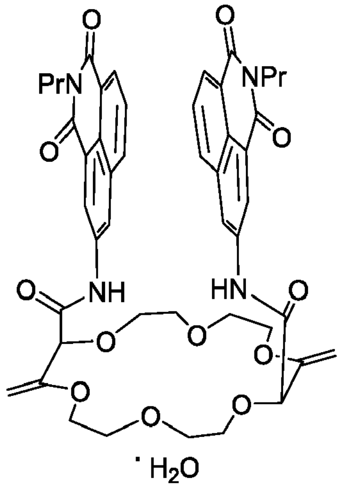

NMI-18C6

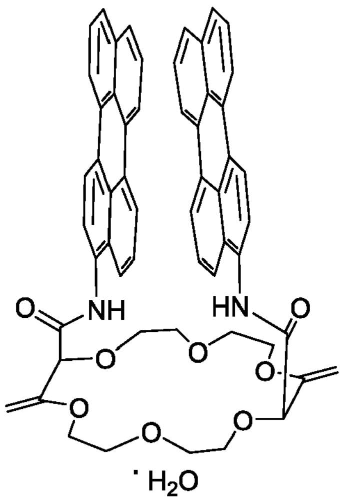

Perylene-18C6

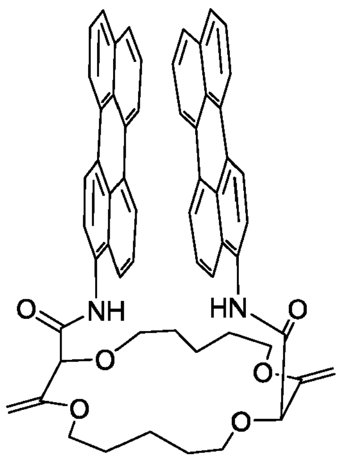

Perylene-18C4

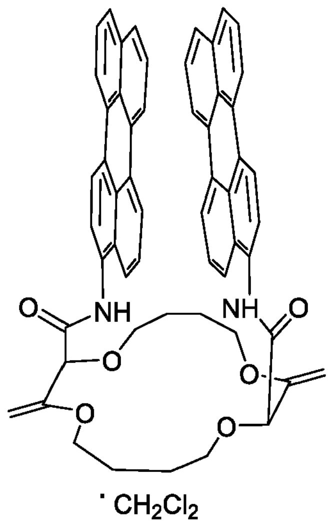

Perylene-16C4

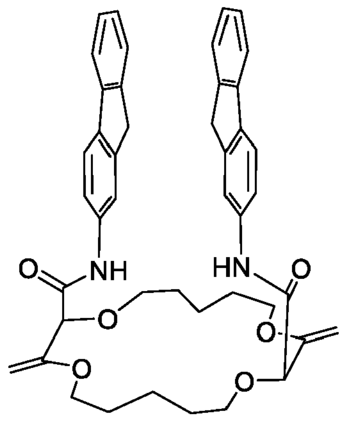

Fluorene-18C4

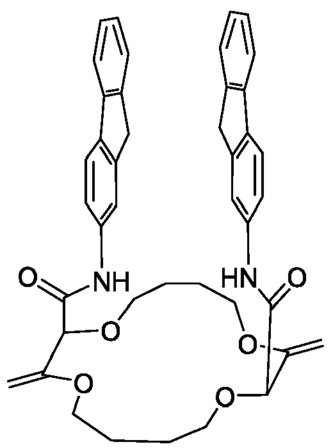

Fluorene-16C4

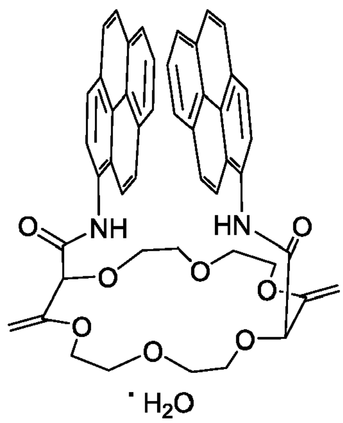

Pyrene-18C6

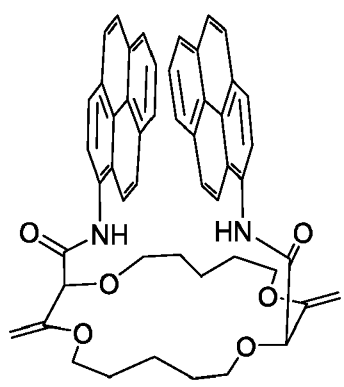

Pyrene-18C4

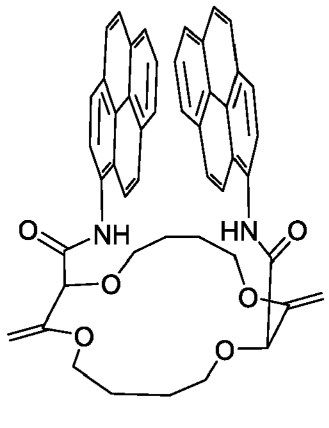

Pyrene-16C4

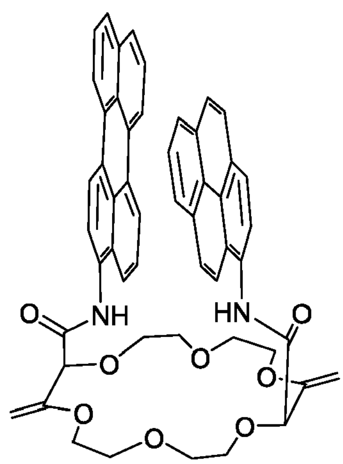

Perylene-pyrene-18C6

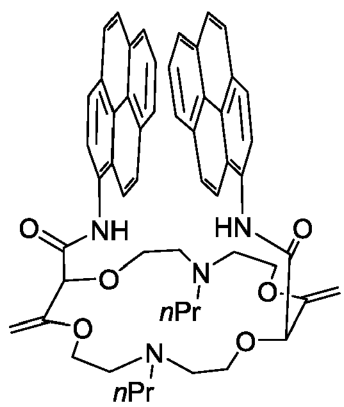

Pyrene-aza-18C6

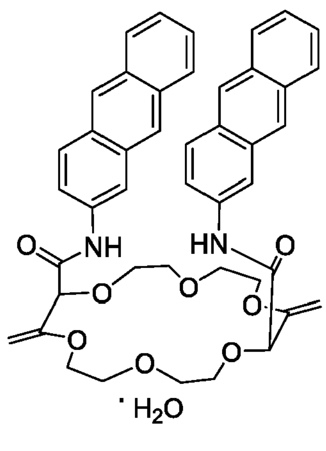

2-Anthracene-18C6

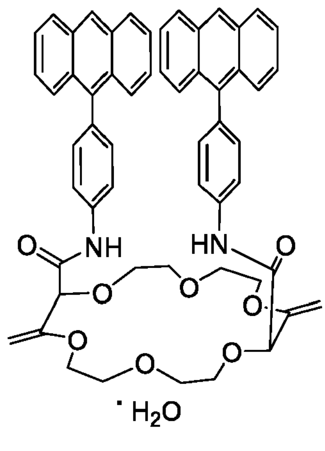

*p*-9-Anthracene-anilide-18C6

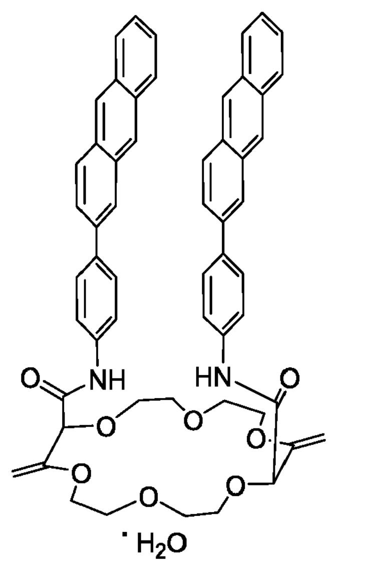

*p*-2-Anthracene-anilide-18C6

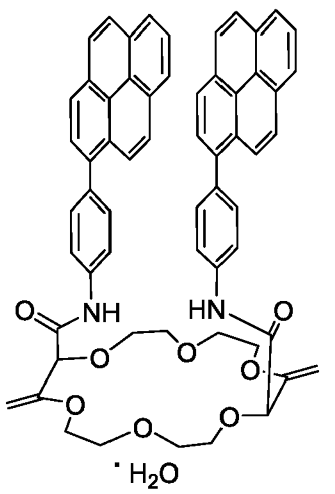

*p*-Pyrene-anilide-18C6

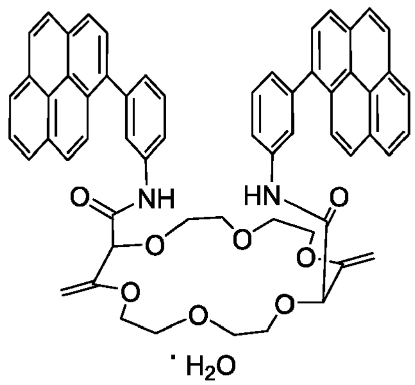

*m*-Pyrene-anilide-18C6

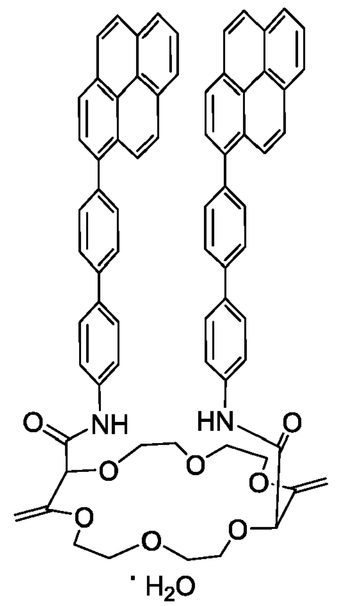

*p*-Pyrene-*p*-Ph-anilide-18C6

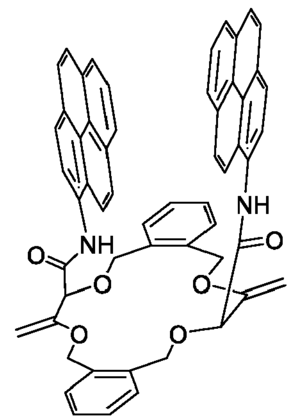

Pyrene-benzo-16C4

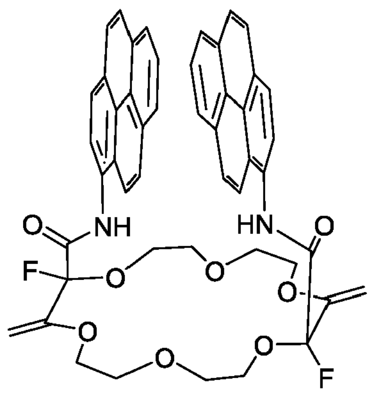

Pyrene-F-18C6

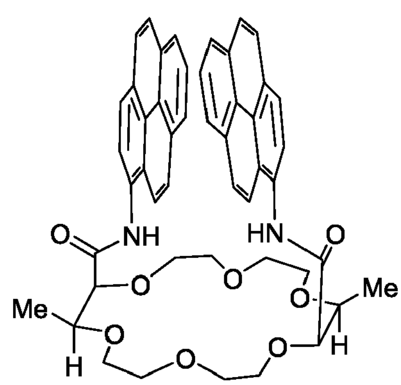

Pyrene-18C6-$H_2$

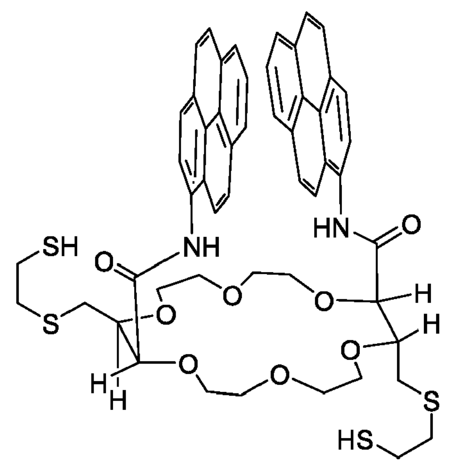

*cis,trans*-Pyrene-18C6-$SCH_2CH_2SH$

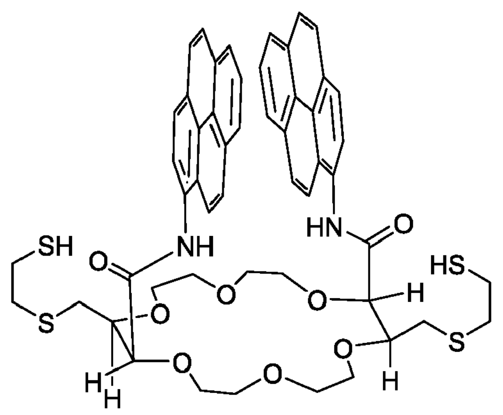

*cis,cis*-Pyrene-18C6-$SCH_2CH_2SH$

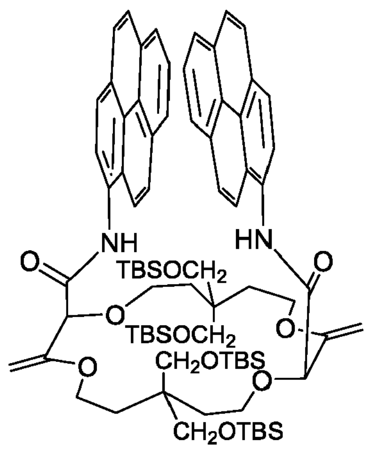

Pyrene-18C4-*gem*di$CH_2$OTBS

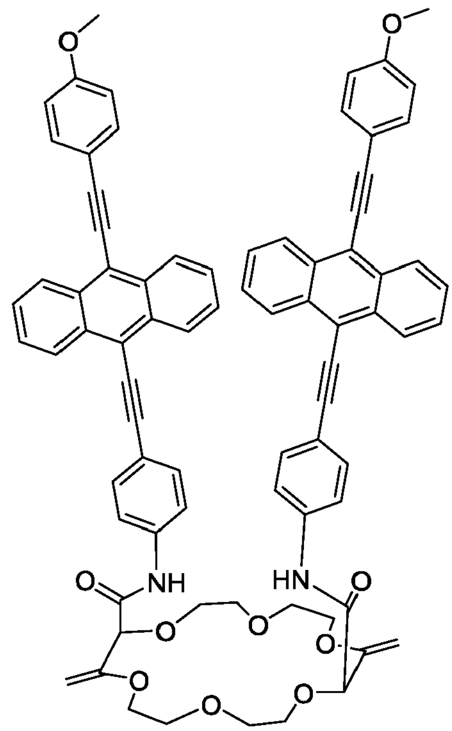

DiPhEthynylAnthracene-18C6

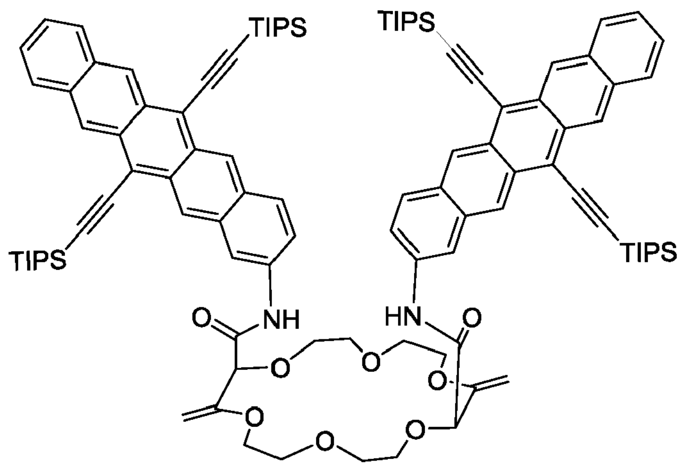

TIPS-Pentacene-18C6

**11.** A security element for the protection of value documents and/or value commercial products comprising the compound of any one of claims 1-10.

**12.** Use of the compound of any one of claims 1-10 against counterfeiting, falsifying and illegal reproduction of value documents and/or value commercial products.

**13.** Method for authenticating a value document and/or a value commercial product, said method comprising the steps of

a) providing a value document and/or a value commercial product carrying at least one compound of any one of claims 1-10 or the security element of claim 11;
b) illuminating the compound or the security element on said value document and/or value commercial product with at least one quality of light from at least one light source;
c) detecting the determined optical characteristics of the compound of any one of claims 1-10 through the

sensing of light emitted by said compounds;
d) determining the value document's and/or the value commercial product's authenticity from the detected optical characteristics of the compound of any one of claims 1-10.

**14.** The method of claim 13, wherein detecting step c) comprises using polarized luminescence spectroscopy to detect circularly polarized luminescence of the compound of any one of claims 1-10.

**15.** Use of the compound of any one of claims 1-10 in organic light emitting diodes (OLED).

**Figure 1**

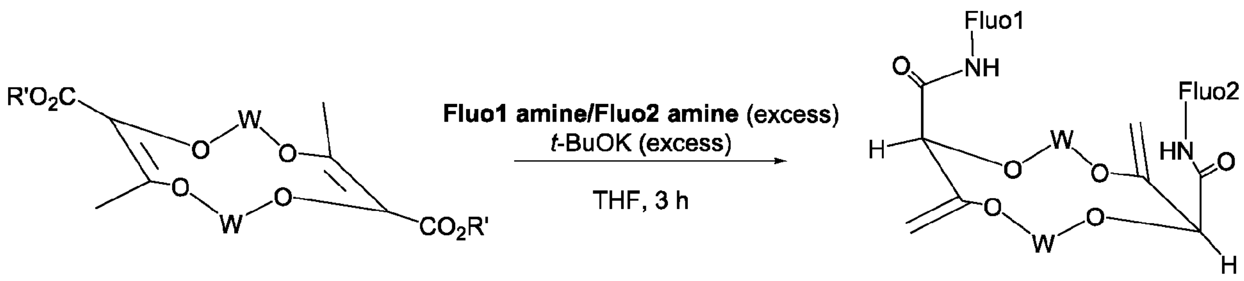


R' is alkyl or aryl

**Figure 2**

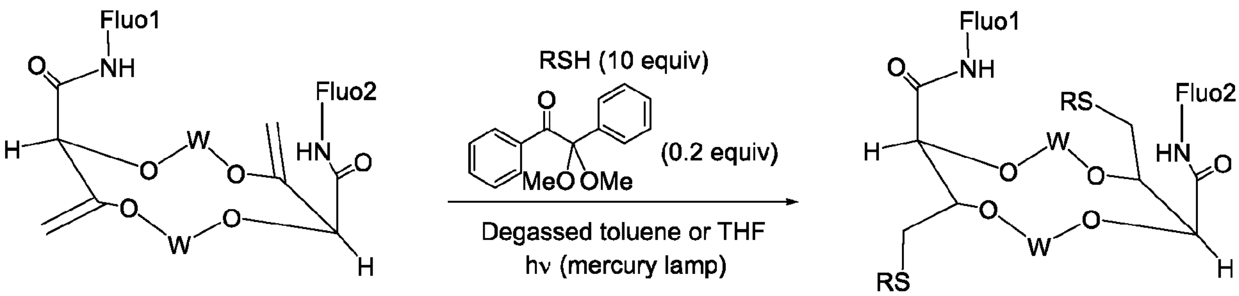
RSH (10 equiv)
(0.2 equiv)
Degassed toluene or THF
hν (mercury lamp)

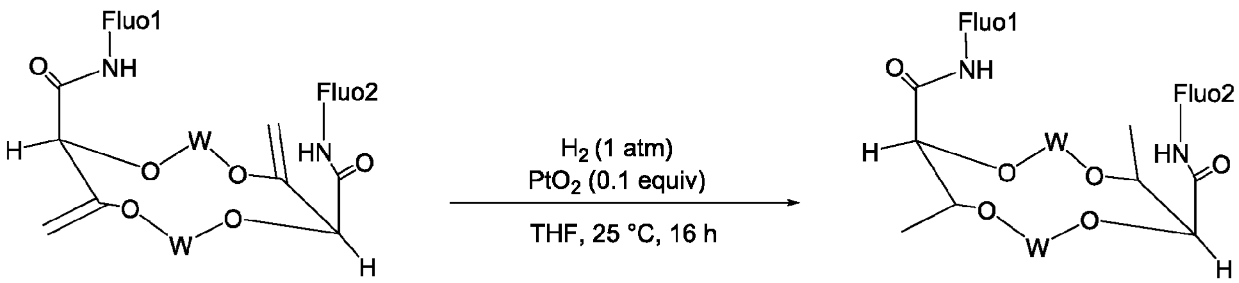
H2 (1 atm)
PtO2 (0.1 equiv)
THF, 25 °C, 16 h

**Figure 3**

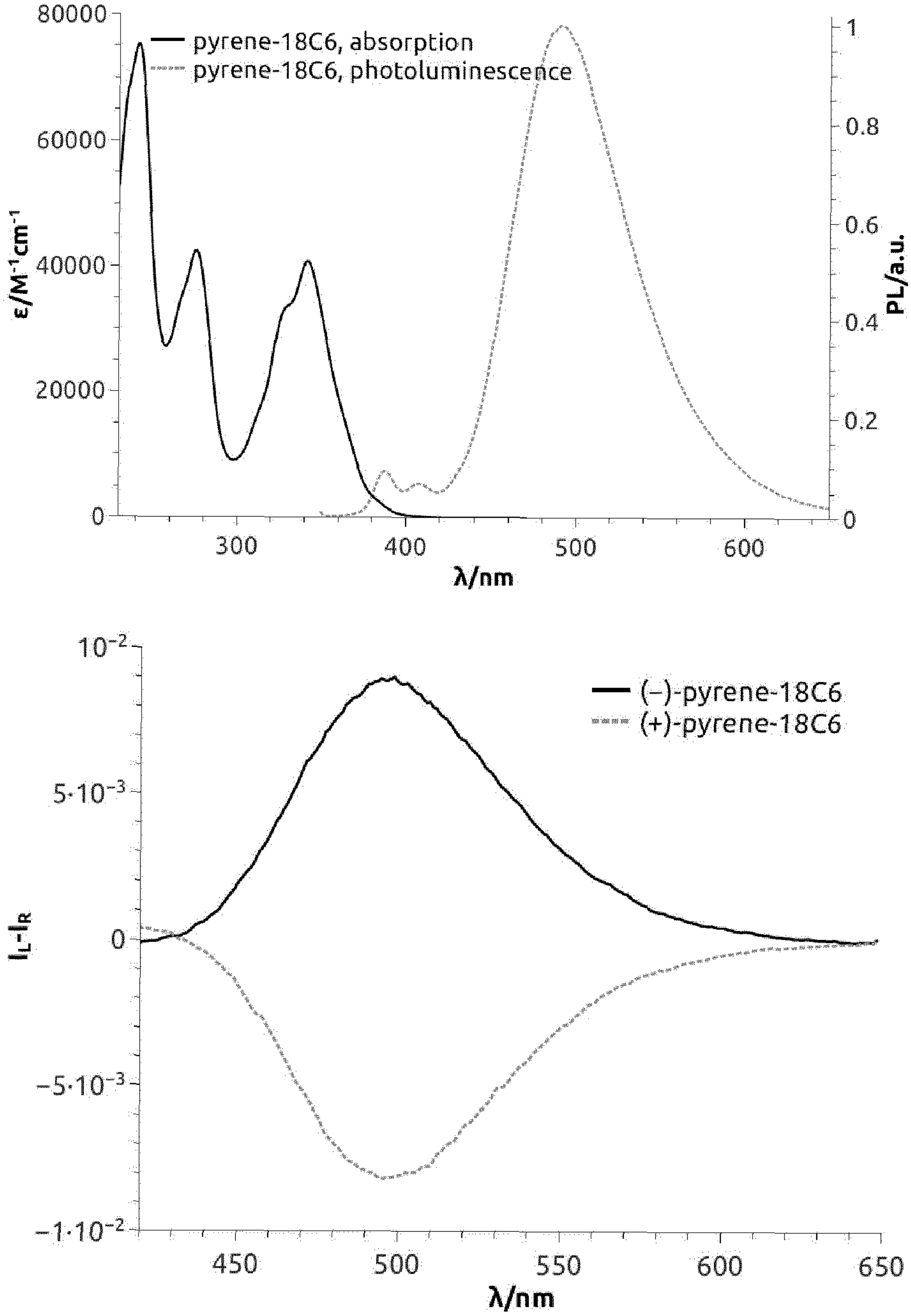
80000
60000
40000
20000
0
ε/M⁻¹cm⁻¹
pyrene-18C6, absorption
pyrene-18C6, photoluminescence
1
0.8
0.6
0.4
0.2
0
PL/a.u.
300
400
500
600
λ/nm
10⁻²
5·10⁻³
0
−5·10⁻³
−1·10⁻²
$I_L$-$I_R$
(−)-pyrene-18C6
(+)-pyrene-18C6
450
500
550
600
650
λ/nm

**Figure 4**

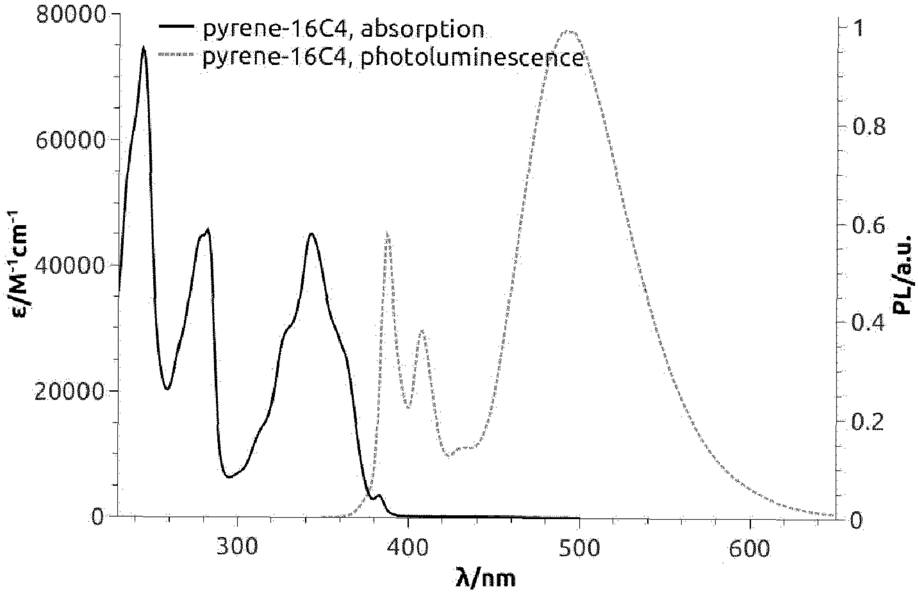
80000
60000
40000
20000
0
ε/M⁻¹cm⁻¹
pyrene-16C4, absorption
pyrene-16C4, photoluminescence
1
0.8
0.6
0.4
0.2
0
PL/a.u.
300
400
500
600
λ/nm

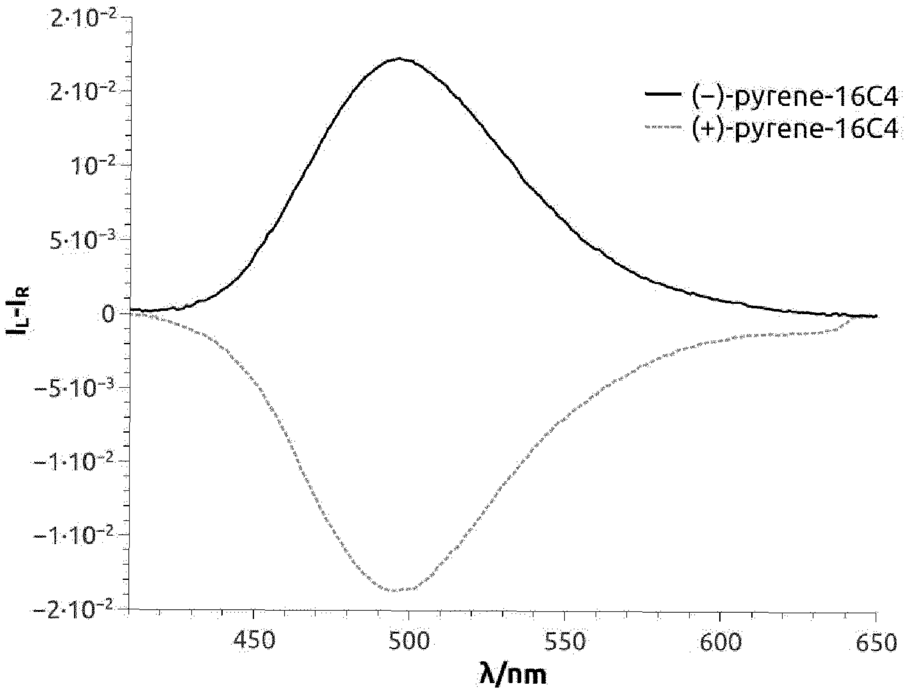
2·10⁻²
2·10⁻²
10⁻²
5·10⁻³
0
−5·10⁻³
−1·10⁻²
−1·10⁻²
−2·10⁻²
I_L-I_R
(−)-pyrene-16C4
(+)-pyrene-16C4
450
500
550
600
650
λ/nm

**Figure 5**

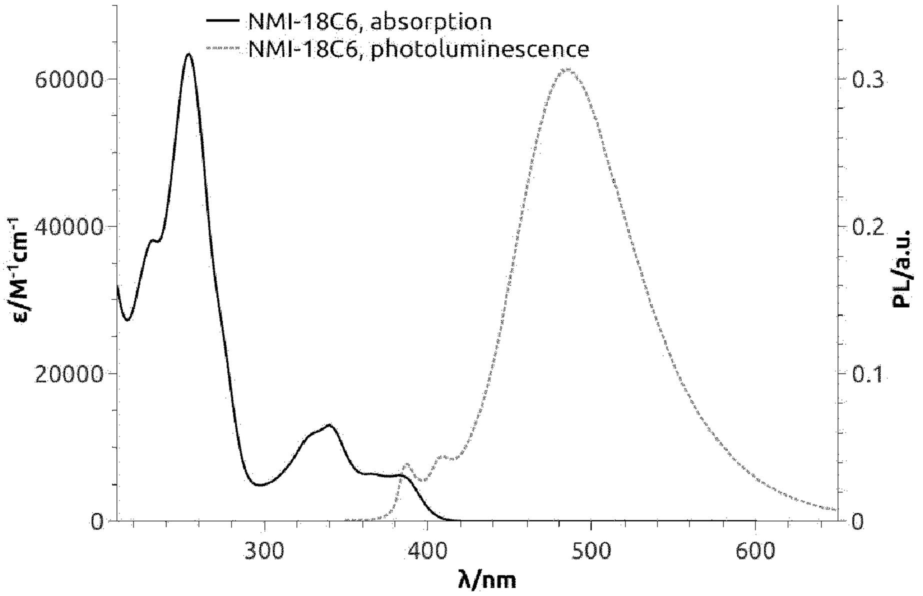
NMI-18C6, absorption
NMI-18C6, photoluminescence
60000
40000
20000
0
ε/M-1cm-1
0.3
0.2
0.1
0
PL/a.u.
300
400
500
600
λ/nm

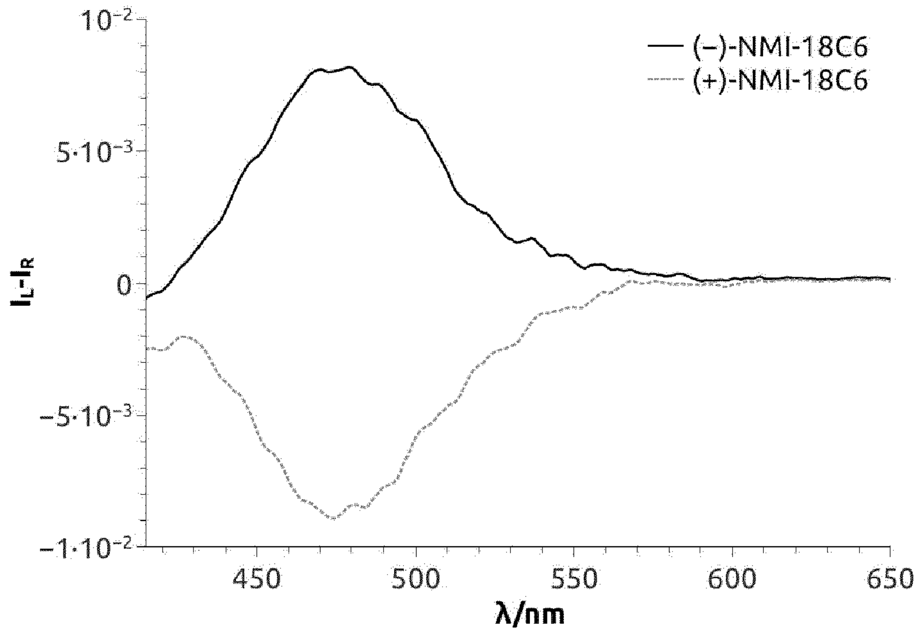
(−)-NMI-18C6
(+)-NMI-18C6
10-2
5·10-3
0
−5·10-3
−1·10-2
IL-IR
450
500
550
600
650
λ/nm

**Figure 6**

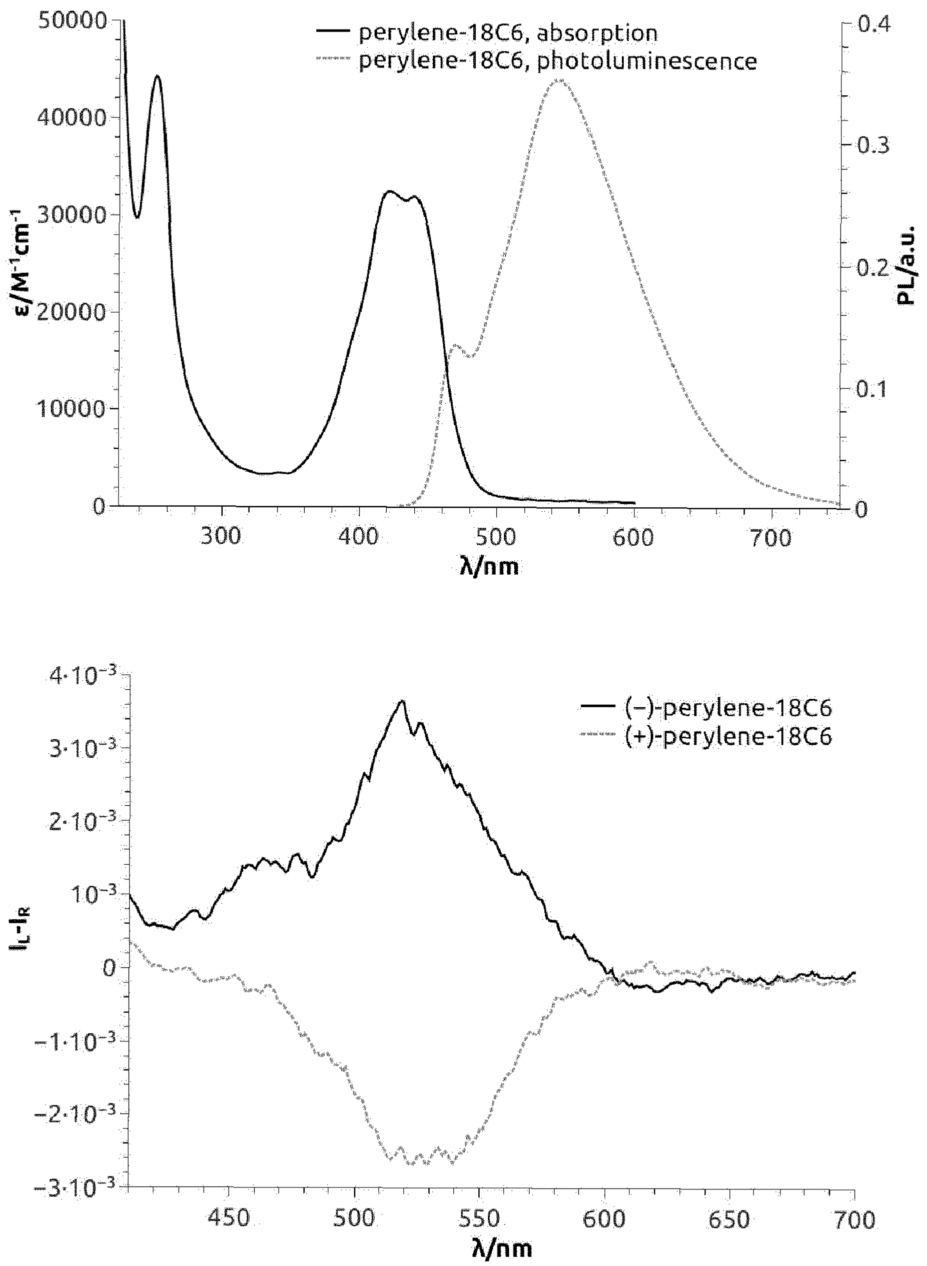

perylene-18C6, absorption
perylene-18C6, photoluminescence
ε/M-1cm-1
PL/a.u.
λ/nm
(−)-perylene-18C6
(+)-perylene-18C6
IL-IR
λ/nm

**Figure 7**

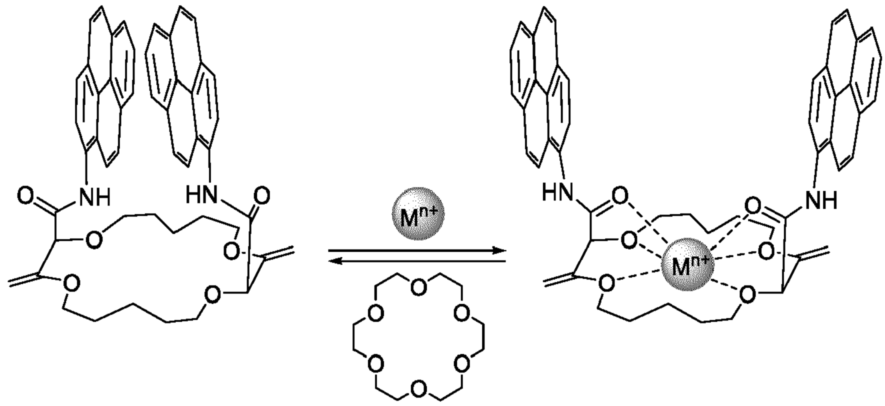

**Figure 8**

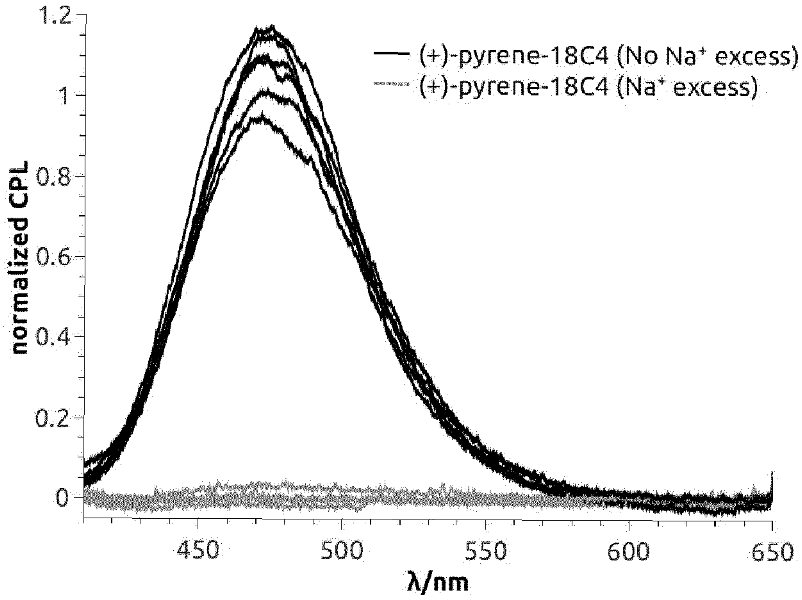
(+)-pyrene-18C4 (No Na+ excess)
(+)-pyrene-18C4 (Na+ excess)
normalized CPL
λ/nm
1.2
1
0.8
0.6
0.4
0.2
0
450
500
550
600
650

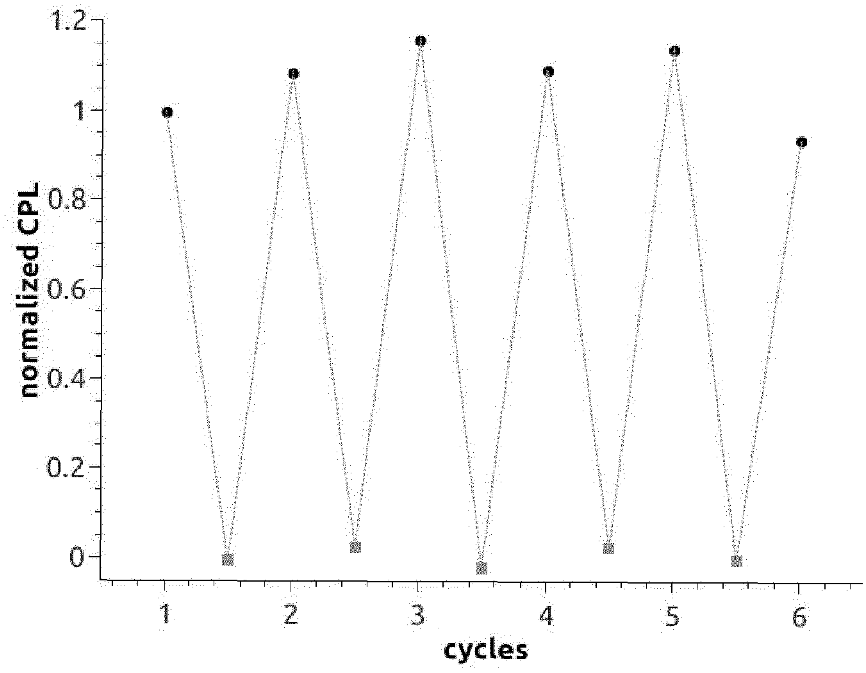
normalized CPL
cycles
1.2
1
0.8
0.6
0.4
0.2
0
1
2
3
4
5
6

Europäisches Patentamt
European Patent Office
Office européen des brevets

# EUROPEAN SEARCH REPORT

Application Number
EP 18 17 1912

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | SUMIT KUMAR RAY ET AL: "Efficient Synthesis of Ditopic Polyamide Receptors for Cooperative Ion Pair Recognition in Solution and Solid States", CHEMISTRY - A EUROPEAN JOURNAL, vol. 24, no. 12, 30 January 2018 (2018-01-30), pages 2944-2951, XP055510904, DE ISSN: 0947-6539, DOI: 10.1002/chem.201704895 | 1,3-9 | INV. C09K11/06 G07D7/00 B42D25/00 H01L51/00 |
| A | * Scheme 1, 2; page 2945 - page 2946; compounds 2a-2c,3a-3d,4-6 * | 2,10-15 | |
| | ----- | | |
| X | STEPHAN SINN ET AL: "A Ratiometric Luminescent Switch Based on Platinum Complexes Tethered to a Crown-Ether Scaffold", CHEMPHYSCHEM - A EUROPEAN JOURNAL OF CHEMICAL PHYSICS & PHYSICALCHEMISTRY., vol. 17, no. 12, 22 March 2016 (2016-03-22), pages 1829-1834, XP055510916, DE ISSN: 1439-4235, DOI: 10.1002/cphc.201501171 | 1-9 | |
| A | * Scheme 1; page 1830 * | 10-15 | |
| | ----- | | |
| | -/-- | | |

TECHNICAL FIELDS SEARCHED (IPC)

C09K
G07D
B42D
H01L

The present search report has been drawn up for all claims

1

| Place of search | Date of completion of the search | Examiner |
|---|---|---|
| The Hague | 1 October 2018 | Mehdaoui, Imed |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

EPO FORM 1503 03.82 (P04C01)

Europäisches Patentamt
European Patent Office
Office européen des brevets

# EUROPEAN SEARCH REPORT

Application Number
EP 18 17 1912

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | MAHESH VISHE ET AL: "Remote stereoselective deconjugation of [alpha],[beta]-unsaturated esters by simple amidation reactions", CHEMICAL SCIENCE, vol. 6, no. 8, 1 January 2015 (2015-01-01), pages 4923-4928, XP055511191, United Kingdom ISSN: 2041-6520, DOI: 10.1039/C5SC01118C | 1,3-9 | |
| A | * page 4924 - page 4925; figures 1,2,4; compounds 3a-4o,8a-10o * | 2,10-15 | |
| A | US 6 232 124 B1 (SELINFREUND RICHARD H [US]) 15 May 2001 (2001-05-15) * claims 1-16; figure 1 * | 1-15 | |
| A | US 2013/140527 A1 (CHEN SHOW-AN [TW] ET AL) 6 June 2013 (2013-06-06) * claims 1-24; examples 1-10 * | 1-15 | |

TECHNICAL FIELDS SEARCHED (IPC)

The present search report has been drawn up for all claims

1

| Place of search | Date of completion of the search | Examiner |
|---|---|---|
| The Hague | 1 October 2018 | Mehdaoui, Imed |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

page 2 of 2

## ANNEX TO THE EUROPEAN SEARCH REPORT ON EUROPEAN PATENT APPLICATION NO. EP 18 17 1912

This annex lists the patent family members relating to the patent documents cited in the above-mentioned European search report. The members are as contained in the European Patent Office EDP file on
The European Patent Office is in no way liable for these particulars which are merely given for the purpose of information.

01-10-2018

| Patent document cited in search report | Publication date | Patent family member(s) | Publication date |
|---|---|---|---|
| US 6232124 B1 | 15-05-2001 | US 6232124 B1<br>US 6458595 B1 | 15-05-2001<br>01-10-2002 |
| US 2013140527 A1 | 06-06-2013 | TW 201323475 A<br>US 2013140527 A1 | 16-06-2013<br>06-06-2013 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- DE 10211310 B4